(19) Europäisches Patentamt

European Patent Office

Office européen des brevets

(11) **EP 1 515 147 B1**

(12) **EUROPEAN PATENT SPECIFICATION**

(45) Date of publication and mention
of the grant of the patent:
**11.07.2018 Bulletin 2018/28**

(51) Int Cl.:
*G01R 27/28* (2006.01)      *H04B 3/466* (2015.01)
*H03M 1/10* (2006.01)      *H03M 1/12* (2006.01)

(21) Application number: **04000859.1**

(22) Date of filing: **16.01.2004**

(54) **Method and apparatus for determining the group delay caused by a device under test**

Verfahren und Vorrichtung zur Bestimmung der von einem zu testenden Bauteil verursachten Gruppenlaufzeit

Procédé et appareil pour determiner le temps de propagation de groupe causé par un dispositif soumis a un essai

(84) Designated Contracting States:
**DE GB**

(30) Priority: **12.09.2003 EP 03020779**

(43) Date of publication of application:
**16.03.2005 Bulletin 2005/11**

(73) Proprietor: **Rohde & Schwarz GmbH & Co. KG**
**81671 München (DE)**

(72) Inventors:
• **Kraus, Jochen**
**D-81667 München (DE)**
• **Kikkert, Cornelis Jan**
**Annandale, Queensland 4814 (AU)**

(74) Representative: **Körfer, Thomas et al**
**Mitscherlich PartmbB**
**Patent- und Rechtsanwälte**
**Postfach 33 06 09**
**80066 München (DE)**

(56) References cited:
GB-A- 797 909      US-A- 3 573 611
US-A- 3 769 585      US-A- 4 039 769

• **EBERSBERGER G ET AL: "TELEVISION SIGNAL DISTORTION IN SURFACE-WAVE FILTERS AND ITS MEASUREMENT" EBU REVIEW- TECHNICAL, EUROPEAN BROADCASTING UNION. BRUSSELS, BE, no. 221, 1 February 1987 (1987-02-01), pages 21-30, XP000068793 ISSN: 0251-0936**
• **KIKKERT C J: "A spread spectrum network analyser" ISSPA'99, FIFTH INTERNATIONAL SYMPOSIUM ON SIGNAL PROCESSING AND ITS APPLICATIONS, 22 - 25 August 1999, pages 733-736, XP002279330 Brisbane, Queensland, Australia**
• **WASSENHOVE VAN D ET AL: "GROUP DELAY MEASUREMENTS OF A TRANSMISSION LINE USING SINGLE CHANNEL MEASUREMENTS" IEEE TRANSACTIONS ON INSTRUMENTATION AND MEASUREMENT, IEEE INC. NEW YORK, US, vol. 39, no. 1, 1 February 1990 (1990-02-01), pages 180-183, XP000101433 ISSN: 0018-9456**
• **ADRIAN JONES, JASON MCMANUS: "Measurement of Group Delay using the 6840 series Microwave System Analyzer with Option 22" APPLICATION NOTE, IFR, vol. a, 2000, pages 1-12, XP002279331 Wichita**

**Description**

The invention relates to a method and an apparatus for determining the group delay caused by a device under test (DUT).

The testing of electronic devices in the test bay in the production or in the laboratory of the R&D-department often includes the measuring of the linear behaviour of the DUT. The linear behaviour of a DUT is characterised by its amplitude distortion and its phase distortion. The phase distortion of an amplitude modulated signal comprises the delay of the carrier signal - phase delay - and the delay of the envelope - group delay - of the amplitude modulated signal. The group delay is the rate of change of phase with frequency.

In the US 4,084,132 a method and an apparatus for recording the group delay of a system under test (SUT) under specific conditions - e.g. specific temperature or stress profiles - is described. The system under test is provided with an amplitude modulated test signal, whose carrier signal's frequency is continuously varied inside a specific wave band. For each frequency of the carrier signal the phase of the test signal and the phase of the phase distorted response signal from the DUT provided with the test signal are detected. The phase difference $\Delta\varphi$ between the test signal and the response signal in combination with the frequency $f_M$ or the angular frequency $\omega_M$ of the modulation signal determines the group delay $\tau_D$ corresponding to equation (1):

$$\tau_D \; = \; \Delta\varphi \; / \; \omega_M \; = \; \Delta\varphi \; / \; (2*\pi*f_M) \; = \; \Delta\varphi \; / \; (360° \; *f_M) \quad (1)$$

The spectrum of the group delay $\tau_D$ is recorded by varying the frequency of the carrier signal, measuring the corresponding phase difference $\Delta\varphi$ and calculating the corresponding group delay $\tau_D$ using equation (1).

The disadvantage of such a method of determining the group delay is the sequential recording of the group delay's spectrum spending a considerable amount of time to receive a spectrum with a fine grid of frequency. The journal article "Television signal distortion in surface-wave filters and its measurement" by G. Ebersberger et al, published in EBU Review/technical on 1 February 1987, pages 21-30, ISSN: 0251-0936, discloses determining a group delay caused by a device under test at a given carrier frequency by generating a modulated test signal comprising an upper and a lower sideband signal using amplitude modulation, by providing this modulated test signal to the device under test, by measuring a phase distorted, modulated response signal, by detecting the phases of two spectral lines of the phase distorted, modulated response signal, and by calculating the group delay based on a phase difference between said phases.

A paper by one of the inventors, describes a measurement technique where a spread spectrum signal is applied to the DUT, so that the amplitude and phase distortion can be made by one measurement, thus overcoming the speed limitations.

Furthermore, both these described methods are only suitable for test systems where the DUT or SUT to be tested can be completely isolated from the signal cables, the probes, the sensors and the converters. Thus the group delay caused by these objects can be detected in a calibration phase by eliminating the DUT or SUT from the test system and replacing it by a calibration DUT, which has a direct connection between the input and output. After calibrating the test system, the group delay caused only by the DUT or SUT can be exactly determined.

If the DUT is an Analogue to Digital Converter (ADC), or a Digital to Analogue Converter (DAC), including their associated analogue circuitry, then the input and output are of a different form, one being an analogue signal and the other a digital signal, so that the measurement system cannot simply be calibrated by removing the DUT and replacing it by the calibration DUT with a direct connection between the input and output.

To use the above measurement techniques, for an ADC and its associated analogue circuitry, a DAC must be included in the test system to make both input and output analogue signals. Since the added DAC has an effect on the group delay, the group delay of the ADC cannot be determined in a fundamental manner. Similarly the measurement of a DAC and its associated circuitry requires the addition of an ADC as part of the DUT, thus preventing the measurement of the group delay of the DAC and its associated circuitry alone.

Therefore, the object of the invention is to develop a fundamental method and an apparatus for rapidly determining the exact group delay of an analogue-digital-converter as DUT without calibrating the test signal generator and the other components of the test system besides the DUT.

The object of the invention is solved by the method for determining the group delay caused by a device under test with the features of claim 1 and an apparatus for determining the group delay caused by a device under test with the features of claim 19.

According to the invention, the DUT is provided with a modulated test signal, whose spectrum contains many precisely defined frequency components. A test signal with such a spectrum is generated by amplitude modulating a carrier signal containing multiple sinewaves of precisely defined frequencies. The modulating signal may be a single Sinewave or it may contain several Sinewaves. The amplitudes of these sinewaves only need to be precisely controlled if the amplitude response of the DUT is to be determined as well as the group delay.. In the preferred embodiment, the modulating frequencies are of a lower frequency than the carrier frequencies, but the modulating frequencies can also be higher than the carrier frequencies. In both these cases a modulated spectrum containing many sum and difference components results. In fact, since multiple sinusoids are modulating multiple sinusoids, the distinction between a carrier signal and a modulating signal is somewhat ambiguous. By defining the ratio of frequency between the carrier signal and the modulation signal, different locations for the intermodulated spectral lines of the test signal in the spectrum can be achieved. The phase distorted response signal from the DUT is detected by a measuring device. After determining the spectral lines of the phase distorted response signal by a Fourier Analyser, the phase difference between matched pairs of modulated sidebands around a carrier is calculated. For a modulating signal spectral line at $F_{mx}$ and a carrier frequency component at $F_{cx}$, these sidebands occur at $\pm F_{mx} \pm F_{cx}$. Two of these four components occur at positive frequencies and two at negative frequencies. The phase difference between the positive frequency sidebands is measured. The group delay caused by the DUT is then the measured phase difference divided by the frequency difference of the sidebands measured above at the average frequency of these sidebands. By using other sideband pairs in the modulated spectrum, the group delay at many frequencies can be calculated from the same Fourier Analysis, so that the complete group delay determination can be done using a single measurement.

One advantage of this method and apparatus for determining the group delay is that by calculating the group delay in the frequency domain, it produces the required phase differences simultaneously in comparison with the sequential determination of the phase differences in US 4,084,132.

The inventive method and apparatus for determining the group delay is, as shown below, independent from the group delay of the test signal generator and of the other units of the apparatus besides the DUT. Thus the group delay of the DUT can be determined without any calibration of the test signal generator and other units of the apparatus. Only the spectrum of the modulator is designed with a wide bandwidth for avoiding a phase distortion of the test signal.

Advantageous embodiments of the invention are described in the dependent claims.

Using an analogue-digital-converter as DUT in a first embodiment of the inventive method and apparatus a discrete response signal has to be measured by a transient analyser and has to be transformed by a digital Fast-Fourier-Analyser in the frequency domain for generating complex spectral lines.

For avoiding a distortion of the spectrum of the discrete response signal by the digital Fast-Fourier-Analyser - i.e. the so called "leakage-effect" - the locations of all the spectral lines of one frequency period have to be adapted to the grid of the N frequency-samples of the digital Fourier-Transformation by a suitable choice of the sampling frequency, the frequency spacing of the spectral components of the modulation signal and the frequency spacing of the spectral components of the carrier signal. Additionally, for minimising the leakage-effect the total time period of the discrete response signal has to be adapted to the grid of the N time-samples of the digital Fourier-Transformation by synchronising the test signal generator and the analogue-digital-converter by means of a clock.

In a second embodiment of the inventive method and apparatus the test signal generator and modulator can be implemented digitally by a digital signal processor calculating an appropriate pulse amplitude modulated test signal. After digital-analogue-converting with a calibrated digital-analogue-converter an analogue amplitude modulated test signal is provided to the DUT. Instead of a single carrier test signal a multiple carrier test signal such as an orthogonal frequency division multiplexing test signal (OFDM) can also be created by the digital signal processor enabling a lowest possible crest-factor by means of an optimised phase in the test signal.

In a third embodiment of the inventive method and apparatus the analogue phase distorted response signal from the DUT has to be converted to a digital phase distorted response signal by a calibrated analogue-digital-converter.

In a fourth embodiment of the inventive method and apparatus the DUT generates an analogue phase distorted response signal and the test signal generator and modulator is realised digitally by a digital signal processor and a succeeding calibrated digital-analogue-converter.

In a fifth embodiment of the inventive method and apparatus the DUT is a digital-analogue-converter generating an analogue phase distorted response signal which is converted to a digital phase distorted response signal by means of a calibrated analogue-digital-converter. The digital-analogue-converter is provided with a digital test signal from a digital signal processor.

In a sixth embodiment of the inventive method and apparatus the sequence of carrier signal is generated digitally by means of a digital signal processor and then converted to an analogue sequence of carrier signal using a digital-analogue-converter for performing an analogue modulation to produce an analogue amplitude modulated test signal.

The embodiments of the invention are displayed in the drawing and are consecutively described in detail. In the drawing:

Fig. 1    shows a diagram of a first embodiment of an apparatus for determining the group delay caused by a device under test;

Fig. 2     shows a spectrum of the amplitude modulated test signal;

Fig. 3     shows a flow chart of the invention method for determining the group delay of a device under test;

Fig. 4     shows a diagram of a second embodiment of an apparatus for determining the group delay caused by a device under test;

Fig. 5     shows a diagram of a third embodiment of an apparatus for determining the group delay caused by a device under test;

Fig. 6     shows a diagram of a fourth embodiment of an apparatus for determining the group delay caused by a device under test;

Fig. 7     shows a diagram of a fifth embodiment of an apparatus for determining the group delay caused by a device under test; and

Fig. 8     shows a diagram of a sixth embodiment of an apparatus for determining the group delay caused by a device under test.

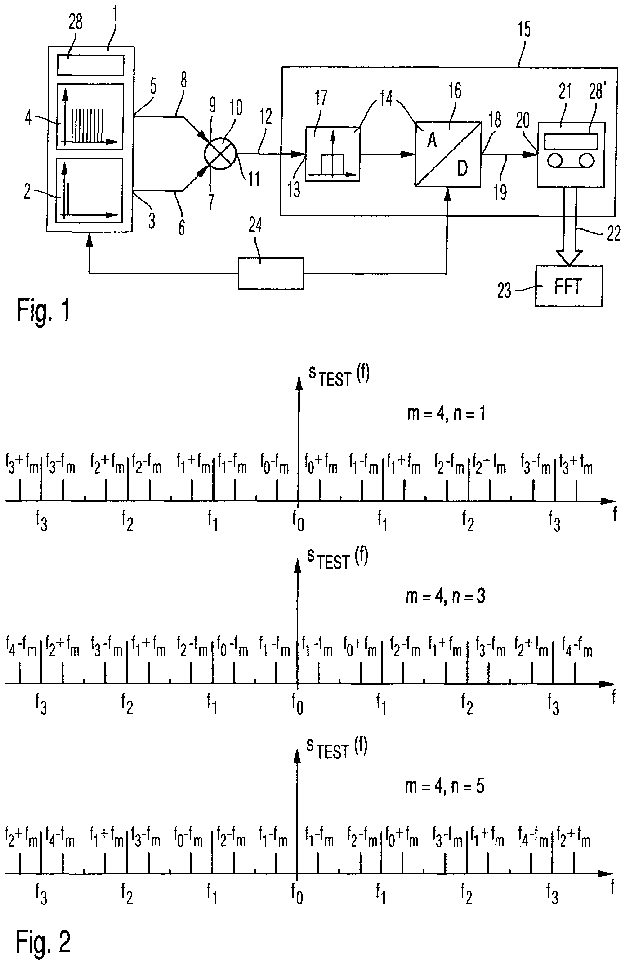

The inventive method and the inventive apparatus for determining the group delay caused by a device under test is consecutively displayed in Figs. 1 to 4.

In Fig. 1 a first embodiment of an inventive apparatus for determining the group delay using an amplitude modulated test signal $s_{test}(t)$ is displayed.

According to Fig. 1 the inventive apparatus consists of a test signal generator 1 producing a modulation signal m(t) with a sequence of frequency components $\omega_m$ in the first signal generation unit 2 and a sequence of carrier signals c(t) in a second signal generation unit 4. The frequency spacing between two frequencies $\omega_K$ and $\omega_{K+1}$ of the sequence of the carrier signals is $\Omega_c$. Thus the frequency $\omega_K$ of each single carrier signal is $K*\Omega_c$, whereas k is a positive integer factor. The frequency spacing between two frequencies $\omega_M$ and $\omega_{M+1}$ of the sequence of the modulating signals is $\Omega_m$. Thus the frequency $\omega_M$ of each single modulating signal is $m*\Omega_m$, whereas m is a positive integer factor. In most practical embodiments of the invention either the modulated signal or the carrier consists of a single Sinewave and the other signal has many spectral components. The modulation signal m(t) is led from output 3 of the test signal generator 1 over signal line 6 to an input 7 of modulator 10, whereas the sequence of carrier signals c(t) is led from output 5 over signal line 8 to an input 9 of the modulator 10. The modulator 10 mixes the modulation signal m(t) with the sequence of carrier signals c(t) to an amplitude modulated test signal $s_{test}(t)$ at the output 11 of the modulator 10. For avoiding additional phase distortion of the amplitude modulated test signal $s_{test}(t)$ by the modulator 10 the frequency band of the modulator 10 is designed to have a large bandwidth.

The modulation signal m(t) can be described by equation (2) :

$$\mathrm{m(t)} \;=\; \sum_{m=1}^{M} A_m * \cos(m*\Omega_m*t+\varphi_m) \;=\; \sum_{m=1}^{M} A_m * \cos(\omega_m*t+\varphi_m) \qquad (2)$$

The sequence of the carrier signals c(t) can be described by equation (3):

$$\mathrm{c(t)} \;=\; \sum_{k=1}^{K} A_k * \cos(k*\Omega_c*t+\varphi_k) \;=\; \sum_{k=1}^{K} A_k * \cos(\omega_k*t+\varphi_k)$$

The phases $\varphi_k$ in the sequence c(t) of the carrier signals should be chosen appropriately to minimise the crest factor.

Thus the amplitude modulated test signal $s_{test}(t)$ results from multiplying the modulation signal m(t) with the sequence of carrier signals c(t) according to equation (4) :

$$\mathrm{s_{test}(t)} \;=\; \mathrm{c(t)}*\mathrm{m(t)} \;=$$
$$\frac{1}{2}\sum_{m=1}^{M}\;\sum_{k=1}^{K}\big[A_m*A_k*\cos((\omega_k+\omega_m)*t+\varphi_k+\varphi_m)+A_k*A_m*\cos((\omega_k-\omega_m)*t+\varphi_k-\varphi_m)\big]$$
$$(4)$$

In practice M or K or both can be one, resulting in a single Sinewave being multiplied by multiple sinewaves to produce a multitone spectrum. Placing two sidebands around each carrier to get better accuracy is an example where both summations in equation 4 above are used.

The amplitude modulated test signal $s_{test}(t)$ is led from output 11 of the modulator 10 over signal line 12 to an input 13 of the device under test (DUT) 14 which can be integrated in a test unit 15. The DUT 14 is an analogue-digital-converter 16 with an optional upstream analogue input circuit 17.

Having passed through the optional analogue input circuit 17, the analogue amplitude modulated test signal $s_{test}(t)$ is converted to a digitally formatted amplitude modulated response signal $s_{resp}(t)$ by the analogue-digital-converter 16. The analogue-digital-converter 16 samples the analogue amplitude modulated test signal $s_{test}(t)$, after it has passed through the analogue input circuit, with a sampling frequency $f_0$. Thereby the digital amplitude modulated response signal $s_{resp}(t)$ at the output 18 of the DUT 14 is distorted in its phase in comparison with the analogue amplitude modulated test signal $s_{test}(t)$ at the input 13 of the DUT 14.

In the case of approximately linear system conditions in the surrounding of each carrier frequency $\omega_K$ as operating points of the DUT 14 the group delay $\tau_k$ describing the phase distortion of the amplitude modulated test signal $s_{test}(t)$ in the DUT 14 at the carrier frequency $\omega_k$ can be according to equation (5) assumed to be constant in the surrounding of each carrier frequency $\omega_k$:

$$\tau_k \; = \; \tau(\omega_k) \; = \; \tau(\omega_k + \omega_m) \; = \; \tau(\omega_k - \omega_m) \tag{5}$$

Therefore, according to equation (5) the group delay caused by the DUT 14 is approximately constant at the carrier frequency $\omega_K$ and its adjacent intermodulation frequencies $\omega_K + \omega_m$ and $\omega_K - \omega_m$ if $\omega_K > \omega_{m'}$ or frequencies $\omega_m + \omega_K$ and $\omega_m - \omega_K$ if $\omega_m > \omega_K$.

To simplify the mathematics describing the invention, in the following description it is assumed that M=1 and $\omega_K > \omega_m$, so that $s_{test}(t)$ becomes

$$s_{test}(t) = \frac{1}{2}\sum_{k=1}^{K}\left[A_m * A_k * \cos((\omega_k + \omega_m)*t + \varphi_k + \varphi_m) + A_k * A_m * \cos(\omega_k - \omega_m)*t + \varphi_k - \varphi_m)\right]$$

with the modulation signal being a single sinewave with amplitude $A_m$ and frequency $\omega_m$. Similar mathematics can be performed for the case where M can be greater than one or where $\omega_K < \omega_m$ leading to the same equation for the calculation of the group delay $\tau_K$ as in the case M=1 and $\omega_K > \omega_m$.

Realising the case $\omega_K < \omega_m$ with a practical upconversion modulator 10, the single Sinewave modulation signal m(t) is applied to the input 9 (LF terminal) of the modulator 10 and the OFDM like sequence of carrier signal c(t) is applied to the input 7 (RF terminal) of the modulator 10. The output is taken from the output 12 (IF port) of the modulator 10. This arrangement will avoid additional distortion of the group delay introduced by the transformers at the inputs 7 and 9 (RF and LF ports) of the mixer 10 to affect the phase relations in $s_{test}(t)$.

Neglecting the quantisation of the amplitude modulated response signal $s_{resp}(t)$, due to the Analogue to Digital Converter, which does not influence the phase distortion of the amplitude modulated response signal $s_{resp}(t)$ in relation to the amplitude modulated test signal $s_{test}(t)$, the amplitude modulated response signal $s_{resp}(t)$ can be described by equation (6) considering equation (5):

$$s_{resp}(t) =$$
$$\sum_{k=1}^{K}A_m * A_k /2*\left[\cos((\omega_k + \omega_m)*(t + \tau_k) + \varphi_k + \varphi_m) + \cos((\omega_k - \omega_m)(t - \tau_k) + \varphi_k - \varphi_m)\right]$$
$$=$$
$$\sum_{k=1}^{K}\alpha_k * [\cos((\omega_k + \omega_m)*t + \omega_k * \tau_k + \varphi_k + \omega_m * \tau_k + \varphi_m) +$$
$$+ \cos((\omega_k - \omega_m)*t + \omega_k * \tau_k + \varphi_m - \omega_m * \tau_k - \varphi_m)] \tag{6}$$

with

$$\alpha_k = A_m * A_k / 2$$

According to equation (6) the phase difference $\Delta\varphi_k$ between the signal components of the response signal $s_{resp}(t)$ at the upper sideband (intermodulation frequency $\omega_K+\omega_m$) and at the lower sideband (intermodulation frequency $\omega_K-\omega_m$) can be determined as in the following described in equation (7):

$$\Delta\varphi_k = 2 * (\varphi_m + \omega_m * \tau_k) \tag{7}$$

Considering equation (7) in the expression of equation (6) the expression for an amplitude modulated response signal $s_{resp}(t)$ with linear conditions in the surrounding of each carrier frequency $\omega_k$ corresponding to equation (8) results in:

$$s_{resp}(t) = \sum_{k=1}^{K} \alpha_k * [\cos((\omega_k + \omega_m)*t + \omega_k*\tau_k + \varphi_k + 1/2*\Delta\varphi_k) + \\ + \cos((\omega_k - \omega_m)*t + \omega_k*\tau_k + \varphi_k - 1/2*\Delta\varphi_k)] \tag{8}$$

According to equation (7) the group delay $\tau_k$ caused by a DUT 14 can be calculated as described in equation (9):

$$\tau_k = \tau(\omega_k) = \frac{\Delta\varphi_k - 2*\varphi_m}{2*\omega_m} \tag{9}$$

The phase difference $\Delta\varphi_k$ between the upper and the lower sideband of the $k^{th}$ carrier signal can be read directly from the complex fourier coefficients of the FAST-Fourier-Transform-spectrum $S_{resp}(f) = FFT(s_{resp}(t))$ obtained from the response signal $s_{resp}(t)$.

In equation (9) the phase of the modulation signal $\varphi_m$ is unknown. However since the same modulation signal is used at each of the many carrier frequency components, the phase of the modulation signal $\varphi_m$ causes the same offset in all the group delay measurements. Using one of the carrier frequency components at $\omega_{k0}$ as a reference allows the group delay to be calculated relative to this reference frequency. The difference of the group delay $\tau_k-\tau_{k0}$ at the carrier frequency $\omega_k$ and at the reference carrier frequency $\omega_{k0}$ being independent of $\varphi_m$ can be used corresponding to equation (10) instead of the group delay

$$\tau_k - \tau_{k0} = \frac{\Delta\varphi_k - \Delta\varphi_{k0}}{2*\omega_m} \tag{10}$$

By using the common clock generator 24 to trigger both the generation of the modulation waveform and the sampling of the measured waveform $s_{resp}(t)$, , or if the recording of $s_{resp}(t)$ can be triggered with respect to the generation of $s_{test}(t)$, then $\varphi_m$ can be compensated for by adjusting the timing relationship between the two.

The calculation of the group delay $\tau_k$ according to equation (9) is only possible in linear phased systems with constant characteristics of the group delay $\tau_k$ in the surrounding of the carrier frequencies $\omega_k$ as operating points of the DUT 14.

In the case of non-linear conditions in the surrounding of each carrier frequency $\omega_k$ as operating points of the DUT 14 the group delay $\tau_k$ in the surrounding of each carrier frequency $\omega_k$ is not constant according to equation (11):

$$s_{resp}(t) = \sum_{k=1}^{K} A_m * A_k / 2 * [\cos((\omega_k + \omega_m)*t + \tau(\omega_k + \omega_m)) + \varphi_k + \varphi_m) + \\ + \cos((\omega_k - \omega_m)(t + \tau(\omega_k - \omega_m)) + \varphi_k - \varphi_m)] \tag{11}$$

A realistic value for the group delay $\tau(\omega_k+\omega_m)$ at the upper sideband (intermodulation frequency $\omega_k+\omega_m$) and for the group delay $\tau(\omega_k-\omega_m)$ at the lower sideband (intermodulation frequency $\omega_K-\omega_m$) can be determined by linear approximation of the group delay $\tau_k$ in the surrounding of each carrier frequency $\omega_k$ as operating points of the DUT 14 as described in equations (12) and (13):

$$\tau(\omega_k+\omega_m) \;=\; \tau(\omega_k) \;+\; \omega_m * \frac{d\tau}{d\omega}\Big|_{\omega_k} = \tau_k + \omega_m * \tau_k' \qquad (12)$$

$$\tau(\omega_k-\omega_m) \;=\; \tau(\omega_k) \;-\; \omega_m * \frac{d\tau}{d\omega}\Big|_{\omega_k} = \tau_k - \omega_m * \tau_k' \qquad (13)$$

Considering the expressions for the group delay $\tau(\omega_k+\omega_m)$ at the upper sideband (intermodulation frequency $\omega_K+\omega_m$) and for the group delay $\tau(\omega_k-\omega_m)$ at the lower sideband (intermodulation frequency $\omega_K-\omega_m$) in equations (12) and (13) in the expression for the amplitude modulated response signal $s_{resp}(t)$ in equation (11) the new expression for the amplitude modulated response signal $s_{resp}(t)$ with non-linear conditions in the surrounding of each carrier frequency $\omega_k$ follows as described in equation (14):

$$s_{resp}(t) = \sum_{k=1}^{K} a_k * [\cos((\omega_k + \omega_m)*(t + \tau_k + \omega_m * \tau_k') + \varphi_k + \varphi_m) + \\ + \cos((\omega_k - \omega_m)*(t + \tau_k - \omega_m * \tau_k') + \varphi_k - \varphi_m)] \qquad (14)$$

Mathematical conversion of the expression in equation (14) results in the expression for the amplitude modulated response signal $s_{resp}(t)$ in equation (15):

$$s_{resp}(t) = \\ \sum_{k=1}^{K} a_k * [\cos((\omega_k + \omega_m)*t + \omega_k * \tau_k + \omega_m^2 * \tau_k' + \varphi_k + \varphi_m + \omega_m * (\tau_k + \omega_k * \tau_k')) + \\ + \cos((\omega_k - \omega_m)*t + \omega_k * \tau_k + \omega_m^2 * \tau_k' + \varphi_k - \varphi_m - \omega_m * (\tau_k + \omega_k * \tau_k'))] \qquad (15)$$

According to equation (15) the phase difference $\Delta\varphi_k$ between the signal components of the response signal $s_{resp}(t)$ at the upper sideband (intermodulation frequency $\omega_K+\omega_m$) and at the lower sideband (intermodulation frequency $\omega_K-\omega_m$) with non-linear conditions in the surrounding of each carrier frequency $\omega_k$ can be determined as described in equation (16):

$$\Delta\varphi_k \;=\; 2 * (\varphi_m + \omega_m * (\tau_k + \omega_k * \tau_k')) \qquad (16)$$

Substituting equation (16) in the expression of equation (15) the expression for the amplitude modulated response signal $s_{resp}(t)$ with non-linear conditions in the surrounding of each carrier frequency $\omega_k$ results as described in equation (17):

$$s_{resp}(t) = \sum_{k=1}^{K} a_k * [\cos((\omega_k + \omega_m)*t + \omega_k * \tau_k + \omega_m^2 * \tau_k' + \varphi_k + \Delta\varphi_k/2) + \\ + \cos((\omega_k - \omega_m)*t + \omega_k * \tau_k + \omega_m^2 * \tau_k' + \varphi_k - \Delta\varphi_k/2)] \qquad (17)$$

For calculating the group delay $\tau(\omega)$ in equation (16) the auxiliary variable T according to equation (18) and (19) is introduced:

$$\Delta\varphi(\omega) \;=\; 2 * (\varphi_m + \omega_m * T(\omega)) \qquad (18)$$

with

$$T(\omega) = \tau(\omega) + \omega(\omega) * \tau(\omega)' = \frac{d}{d\omega}(\omega * \tau(\omega)) \tag{19}$$

The group delay $\tau_k$ can be calculated by integrating the expression in equation (18) as described in equation (19):

$$\tau(\omega) = 1/\omega * \int_{u=0}^{\omega} T(u)\,du \tag{19}$$

Equation (19) does not contain an integration constant, since the group delay $\tau(0)$ is zero by definition.

The auxiliary variable $T(\omega)$ is unknown. Thus instead of $T(\omega)$ an expression for $T(\omega)$ deduced from equation (18) is used as described in equation (20):

$$T(\omega) = 1/\omega_m * (\Delta\varphi(\omega)/2 - \varphi_m) \tag{20}$$

Introducing the expression of equation (20) in the expression of equation (19) the expression for the group delay $\tau(\omega)$ in equation (21) results in:

$$\tau(\omega) = 1/(\omega * \omega_m)\int_{u=0}^{\omega}(\Delta\varphi(u)/2 - \varphi_m)\,du = \frac{1}{2\cdot\omega\cdot\omega_m}\int_{u=0}^{\omega}\Delta\varphi(u)\,du - \frac{\varphi_m}{\omega_m} \tag{21}$$

If the difference of frequency $\Omega$ between each carrier frequency $\omega_k$ becomes smaller with the consequence of an approximately constant phase difference $\Delta\varphi(\omega)$ in the frequency band between two carrier frequencies $\omega_k$ and $\omega_{k+1}$, the continuous integral can be replaced by a numerical integral as described in equation (22):

$$\tau(\omega_k) = \Omega_c/(2*\omega_k*\omega_m) * \sum_{n=0}^{k}\Delta\varphi(\omega_n) - \varphi_m/\omega_m \tag{22}$$

In the expression in equation (22) two variables - the phase difference $\Delta\varphi(\omega=0)$ at DC and the phase of the modulation signal $\varphi_m$ - are unknown or cannot be measured.

An approximation expression for $\Delta\varphi_0$ can be determined by linear extrapolation of $\Delta\varphi(\omega)$ in the surrounding of the operation point at $\Delta\varphi_1$ corresponding to equation (23):

$$\Delta\varphi_0 \approx \Delta\varphi_1 - (\Delta\varphi_2 - \Delta\varphi_1) = 2*\Delta\varphi_1 - \Delta\varphi_2 \tag{23}$$

Assuming that both the group delay $\tau(0)$ and the differential group delay $\tau'(0)$ are zero, the phase differences $\Delta\varphi_1$ and $\Delta\varphi_2$ are approximately equal and therefore the phase difference $\Delta\varphi_0$ is approximately equal to the phase difference $\Delta\varphi_1$ corresponding equation (23). The problem with the unknown phase of the modulation signal $\varphi_m$ in the expression of equation (22) can be solved by using the common clock generator 24 to trigger both the recording of $s_{resp}(t)$ and the generation of $s_{test}(t)$, as stated above, or by using the difference of the group delay $\tau_k-\tau_{k0}$ at the carrier frequency $\omega_k$ and at the reference carrier frequency $\omega_{k0}$ corresponding to equation (24), which is independent of the phase of the modulation signal $\varphi_m$:

$$\tau_k - \tau_{k0} = \Omega_c/(2*\omega_m)[1/\omega_k * \sum_{n=0}^{k}\Delta\varphi(\omega_n) - 2*\varphi_m/\Omega_c - (1/\omega_{k0} * \sum_{n=0}^{k0}\Delta\varphi(\omega_n) -$$

$$2*\varphi_m/\Omega_c)] = \Omega_c/(2*\omega_m)[1/\omega_k * \sum_{n=0}^{k}\Delta\varphi(\omega_n) - 1/\omega_{k0} * \sum_{n=0}^{k0}\Delta\varphi(\omega_n)] \tag{24}$$

For determining the group delay $\tau_k$ at each carrier frequency $\omega_k$ corresponding to equation (9) or (10) in the linear case and corresponding to equation (22) or (24) in the non-linear case the phase distorted amplitude modulated response signal $s_{resp}(t)$ is led from output 18 of the DUT 14 over signal line 19 to the input 20 of a transient analyser 21. The transient analyser 21 periodically measures the discrete phase distorted amplitude modulated response signal $s_{resp}(t)$ periodically at a sampling frequency $f_0$ imaging a period of the amplitude modulated response signal $s_{resp}(t)$ to a time frame of N discrete sampling instances. The periodically recorded response signal $s_{resp}(t)$ is transmitted from the transient analyser 21 over a data bus 22 to a digital Fast-Fourier-Analyser 23.

In the Fast-Fourier-Analyser 23 the spectrum of the discrete response signal $s_{resp}(t)$ is detected. The Fast-Fourier-Analyser 23 identifies the levels of the N sampling instances of the discrete response signal $s_{resp}(t)$ in the time frame at a sampling frequency $f_0$. Based on the N discrete time samples of the time frame the Fast-Fourier-Analyser 23 calculates the N spectral lines within the frequency frame using a Fast-Fourier-algorithm. Instead of a Fast-Fourier-algorithm, one could also use the more general DFT-(i.e. Discrete-Fourier-Transform-)algorithm.

For realising a frequency frame with N non-distorted spectral lines, the following requirements for the amplitude modulated test signal $s_{test}(t)$ and the amplitude modulated response signal $s_{resp}(t)$ have to be satisfied:

- The spectral lines of the intermodulation signal components in the amplitude modulated test signal $s_{test}(t)$ each have different frequencies. In a practical implementation, one will also avoid that these frequencies coincide with other frequency components in $s_{test}(t)$, such as the carrier frequencies $\omega_k$ and 3rd order intermodulation products at frequencies $\omega_k \pm 2^*\omega_m$.
- The periodicity of the discrete amplitude modulated response signal $s_{resp}(t)$ into the time frame of the N sampling instances of the Fast-Fourier-Transformation has to be met (i.e. the periodicity requirements of Fourier Series are satisfied.).
- The periodically repeated spectra of the discrete amplitude modulated test signal $s_{test}(t)$ do not overlap (i.e. aliasing effect).

$$\frac{\Omega_c}{m} = \frac{\omega_m}{n} = f_{ref} = \frac{2\pi f_0}{N}$$

For complying with the first requirement, the frequency $f_c$ of each carrier signal of the sequence c(t) of the carrier signals and the frequency $f_m$ of the modulation signal m(t) - both derived from the reference frequency $f_{ref}$ according to equation (26) and (27) - can only take specific values.

$$f_c = k * \Omega_c = k * (m * f_{ref}) \qquad (26)$$

$$f_m = n * f_{ref} \qquad (27)$$

fc, fc$\pm$2*fm, and fc$\pm$fm are chosen not to coincide, according to Fig. 2, by an m factor of 4, an odd n factor (n = 1, 3, 5 ...) and a positive integer k factor (k = 1, 2, 3,..). Fig. 2 shows the spectrum of an amplitude modulated test signal $s_{test}(t)$ for three sets of parameters (top diagram: m = 4, n = 1, k = 1, 2, 3...; middle diagram: m = 4, n = 3, k = 1, 2, 3...; bottom diagram: m = 4, n = 5, k = 1, 2, 3...). It should be noted that there are other possible combinations of k, m and n, which satisfy these requirements. In addition the amplitudes of some carriers can be made zero, resulting in an irregular spectrum

In Fig. 2 the long lines are the spectral lines of the sequence of the carrier signals, whereas the short lines are the spectral lines of the intermodulation signal components of the amplitude modulated test signal $s_{test}(t)$.

The second requirement can be realised by imaging exactly one or integer multiples of a period of the amplitude modulated response signal $s_{resp}(t)$ in the time frame $N/f_0$ of the Fast-Fourier-Transformation. The amplitude modulated response signal $s_{resp}(t)$ in the linear and in the non-linear case is a complex signal according to equations (6), (8), (11), (14), (15) and (17), whose period cannot be determined easily. For this reason, the fundamental frequency $\Omega_c$ of the sequence c(t) of the carrier signals and the frequency $\omega_m$ of the modulation signal m(t) describing the periodicity of the complex amplitude modulated response signal $s_{resp}(t)$ are all chosen to be integer multiples of a frequency $f_{ref}$ as given by equation (27) to ensure an integration of all the periodicities of the complex amplitude modulated response signal $s_{resp}(t)$ into the time frame of the Fast-Fourier-Transformation.

$$\frac{\Omega_c}{m} = \frac{\omega_m}{n} = f_{ref} = \frac{2\pi f_0}{N}$$

(25)

Neglecting the condition in equation (25) results in the periodicity requirements of the Fast Fourier Transform not being satisfied, leading to undesirable distortion of the spectral lines in the frequency frame of the Fast-Fourier-Transformation, i.e. leakage effect.

The third requirement can be achieved by avoiding aliasing; i.e. overlapping of the periodically repeated spectra of the discrete amplitude modulated test signal $s_{test}(t)$ due to the sampling frequency. The overlapping can be avoided by limiting the frequency band of the amplitude modulated test signal $s_{test}(t)$ to less than half the sampling frequency $f_0$ by means of an anti-aliasing filter 28 in the test signal generator 1 and / or an anti-aliasing filter 28' in the measuring device 21. Or, in the case of IF sampling, where $s_{test}(t)$ consists of frequencies higher than $f_0$, spectral overlaps can be avoided if $s_{test}(t)$ is restricted to frequency bands ranging from $(u-1/2)*f_0$ to $(u+1/2)*f_0$ with integer u.

Furthermore to avoid additional aperiodicity in the amplitude modulated response signal $s_{resp}(t)$ in relation to the periodicity of the amplitude modulated test signal $s_{test}(t)$, whose periodicity factors $\Omega_c$ and $\omega_m$ are exactly set by the test signal generator 1, the signal test generator 1 and the analogue-digital-converter 16 are synchronised by a common clock generator 24. Thus synchronism between the amplitude modulated test signal $s_{test}(t)$ and the amplitude modulated response signal $s_{resp}(t)$ is reached.

From the complex Fourier coefficients of the Fast-Fourier-Transform-spectrum $S_{resp}(f)$ determined from the amplitude modulated response signal $s_{resp}(t)$ by the Fast-Fourier-Analyser, the phases of the spectral lines at the upper and at the lower sideband ($\omega_k+\omega_m$, $\omega_k-\omega_m$) for each carrier frequency $\omega_k$ can be detected as described above. The phase difference $\Delta\varphi_k$ between the upper and the lower sideband ($\omega_k+\omega)_m$, $\omega_k-\omega_m$ for each carrier frequency $\omega_k$ is calculated, and the spectrum of the group delay $\tau(\omega_k)$ for all carrier frequencies $\omega_k$ according to the expression in equation (9) and (10) -linear case- and (22), (23), (24) - non-linear case- is determined.

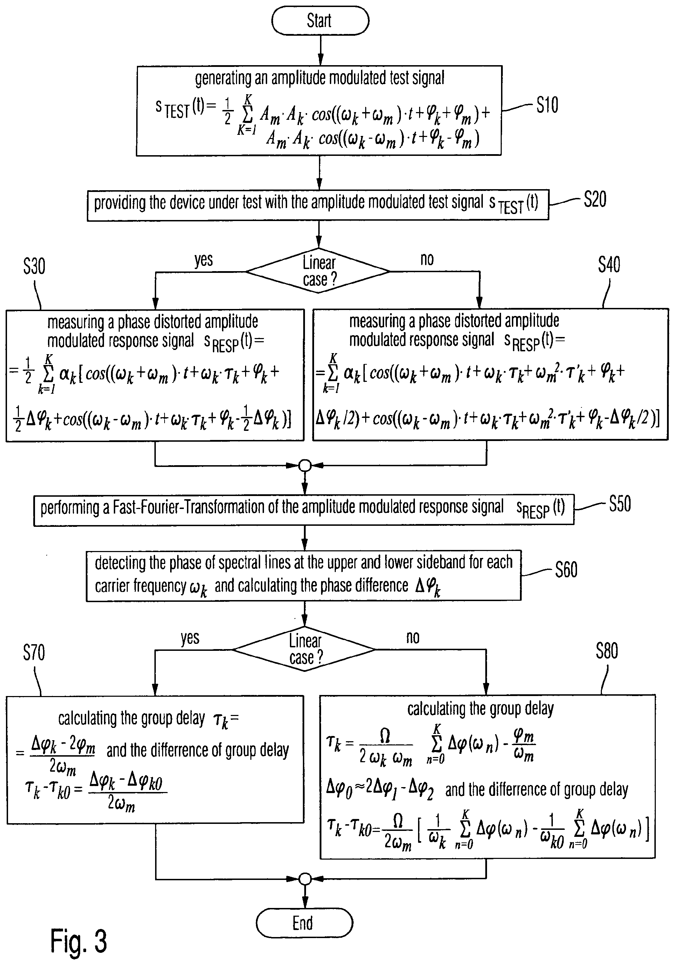

The method for determining the group delay can be described by a flow chart shown in Fig. 3.

In the first step S10 of the method for determining the group delay an amplitude modulated test signal $s_{test}(t)$ corresponding to equation (4) is generated. The amplitude modulated test signal $s_{test}(t)$ is generated by mixing a sequence c(t) of carrier signals corresponding to equation (3) with a modulation signal m(t) corresponding to equation (2).

In step S20 of the method for determining the group delay the amplitude modulated test signal $s_{test}(t)$ generated in step S10 is provided to the device under test 14 consisting of an analogue-digital-converter 16 and an upstream analogue input circuit 17.

The phase distorted amplitude modulated response signal $s_{resp}(t)$ at the output 18 of the analogue-digital-converter 16 in the linear case corresponding to equation (8) is measured with an transient analyser 21 in step S30, whereas the phase distorted amplitude modulated response signal $s_{resp}(t)$ at the output 18 of the analogue-digital-converter 16 in the non-linear case corresponding to equation (17) is measured with a transient analyser 21 in step S40.

In step 50 the measured amplitude modulated response signal $s_{resp}(t)$ of step S30 or step S40 is transformed in the frequency domain using a Fast-Fourier-Transformation in a digital Fast-Fourier-Analyser 23.

In step S60 for each carrier frequency $\omega_K$ the phase of the spectral lines at the upper and lower sideband ($\omega_K+\omega_m$, $\omega_K-\omega_m$) is detected. The phase difference $\Delta\varphi_K$ for each carrier frequency $\omega_K$ is calculated by subtracting the phase of the spectral lines at the upper and the lower sideband of each carrier frequency $\omega_K$.

The group delay $\tau_K$ for each carrier frequency $\omega_K$ and the difference of group delay $\tau_K-\tau_{K0}$ for each carrier frequency $\omega_K$ in relation to a reference carrier frequency $\omega_{K0}$ is calculated in step S70 for the case of linear phase corresponding to equation (9) resp. (10) and in step S80 for the case of non-linear phase corresponding to equation (22) and (24). In step S80 an approximation for the non-measurable phase difference $\Delta\varphi_0$ at the carrier frequency $\omega_0$ corresponding to equation (23) is performed.

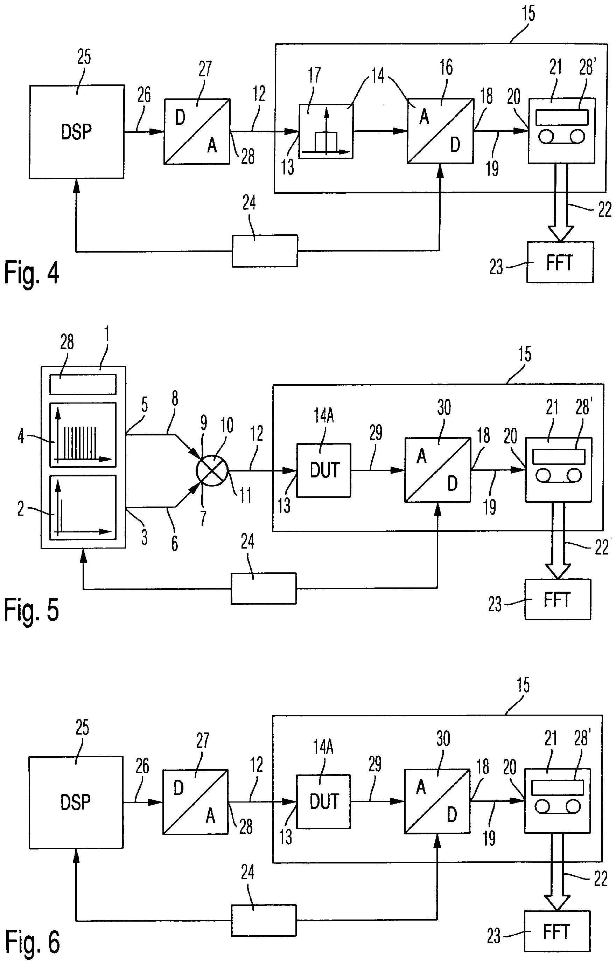

In Fig. 4 a second embodiment of an inventive apparatus for determining the group delay is displayed. In Fig. 4 and consequently in the following Figs. 5 to 7 the same reference signs are used for same features as in Fig. 1 for the first embodiment of the inventive apparatus for determining the group delay.

According to Fig. 4 the amplitude modulated test signal $s_{test}(t)$ is implemented digitally by a digital signal processor 25. After transferring the digital pulse amplitude modulated test signal $s_{testD}(t)$ over signal line 26 to the digital-analogue-converter 27 the analogue amplitude modulated test signal $s_{test}(t)$ is generated at the output 28 of the digital-analogue-converter 27 and provided to the DUT 14.

Normally the amplitude modulated test signal $s_{test}(t)$ resp. $s_{testD}(t)$ is distorted in its phase by the digital-analogue-converter 27. The group delay of the digital-analogue-converter 27 has to be determined in a preceding calibration phase in order to achieve a correct group delay, caused only by the DUT 14, with the inventive method and apparatus.

The third embodiment of the inventive apparatus for determining the group delay in Fig. 5 is characterised by a device under test (DUT) 14A generating an analogue amplitude modulated response signal $s_{resp}(t)$. The analogue amplitude modulated response signal $s_{resp}(t)$ is fed over signal line 29 to a previously calibrated analogue-digital-converter 30 for generating a digital amplitude modulated response signal $s_{respD}(t)$ at the output 18. The DUT 14A is provided at its input 13 with an analogue amplitude modulated test signal $s_{test}(t)$ from a test signal generator 1 and a succeeding modulator 10 corresponding to the first embodiment of the inventive apparatus in Fig. 1.

The fourth embodiment of the inventive apparatus in Fig. 6 consists of the same device under test 14A and the same succeeding and previously calibrated analogue-digital-converter 30 as in the third embodiment in Fig. 5. The analogue amplitude modulated test signal $s_{test}(t)$ is implemented digitally by a digital signal processor 25 and a succeeding calibrated digital-analogue-converter 27 corresponding to the second embodiment of the inventive apparatus in Fig. 4.

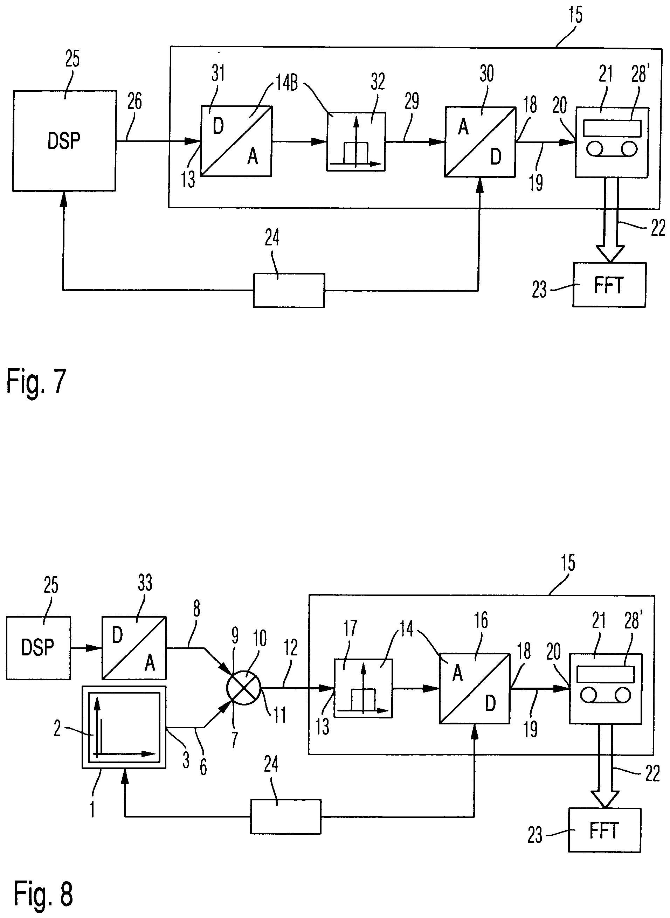

In the fifth embodiment of the inventive apparatus in Fig. 7 the device under test 14B is a digital-analogue-converter 31 and preferably with a downstream output circuit 32. The digital-analogue-converter 31 generates an analogue amplitude modulated response signal $s_{resp}(t)$ which is converted to a digital amplitude modulated response signal $s_{respD}(t)$ by a calibrated analogue-digital-converter 30 corresponding the third and the fourth embodiment of the inventive apparatus in Fig. 5 and 6. The digital-analogue-converter 31 with the downstream output circuit 32 serving as DUT is provided with a digital amplitude modulated test signal $s_{testD}(t)$. The digital amplitude modulated test signal $s_{testD}(t)$ is generated by a digital signal processor 25 corresponding to the second and fourth embodiment of the inventive apparatus in Fig. 2 and 4.

In the sixth embodiment of the inventive apparatus in Fig. 8 the sequence c(t) of carrier signals is generated digitally by a digital signal processor 25 and then converted to an analogue sequence of carrier signal c(t) using a Digital to Analogue Converter 33. An analogue modulator 10 is then used to produce the analogue amplitude modulated test signal $s_{test}(t)$.

In the second, fourth and fifth embodiment of the inventive apparatus for determining the group delay $\tau$ in Figs. 4, 6 and 7 the digital signal processor 25 can also be used for generating a digital orthogonal frequency division multiplexing (OFDM) test signal $s_{testOFDM}(t)$. In the digital signal processor 25 an OFDM modulator is implemented for generating the digital orthogonal frequency division multiplexing test signal (OFDM) $s_{testOFDM}(t)$ fulfilling the same requirements as the amplitude modulated test signal $s_{test}(t)$ resp. response signal $s_{resp}(t)$ described above. The digital orthogonal frequency division multiplexing test signal $s_{testOFDM}(t)$ has a spectrum $s_{testOFDM}(f)$ corresponding to equation (28) with a plurality of equally spaced spectral lines similar to the spectrum of the amplitude modulated test signal $s_{test}(t)$.

$$S_{\text{testOFDM}}(f) \;=\; \sum_{k=0}^{n} |s_k| * e^{j\varphi k} * si(\pi * T_{Nutz} * (f - \frac{k}{T_{Nutz}})) \tag{28}$$

whereas

$s_k$     is the amplitude of the $k^{th}$ sub symbol of the orthogonal frequency division multiplexing test signal $s_{testOFDM}(t)$ in the time domain,

$\varphi_k$     is the phase of the $k^{th}$ sub symbol of the orthogonal frequency division multiplexing test signal $s_{testOFDM}(t)$ in the frequency domain and

$T_{nutz}$     is the duration of a symbol of the orthogonal frequency division multiplexing test signal in the time domain.

The generation of the OFDM test signal $s_{testOFDM}(t)$ in the digital signal processor 25 enables an optimised crest factor of the OFDM test signal $s_{testOFDM}(t)$ by choosing optimised phases of the n bits of a symbol in the OFDM test signal $s_{testOFDM}(t)$.

The digital OFDM test signal $s_{testOFDM}(t)$ is transmitted from the digital signal processor 25 in the case of the fifth embodiment of the inventive apparatus for determining the group delay $\tau$ over the signal line 26 directly to the input 13 of the digital-analogue-converter 31 as DUT and in the case of the second and the fourth embodiment of the inventive apparatus for determining the group delay $\tau$ to the digital-analogue-converter 27 for converting the digital OFDM test signal $s_{testOFDM}(t)$ to an analogue OFDM test signal $s_{testOFDM}(t)$ providing the DUT 14 resp. 14A at the analogue input 13.

For the sixth embodiment, the carrier frequency components can be generated in an OFDM like manner such that a low crest factor is obtained as above.

While the invention has been shown and described with reference to the above displayed embodiments thereof, it will be understood by those skilled in the art that various changes in form and details may be made therein without departing from the scope of the invention as defined by the appended claims.

**Claims**

1. A method of determining the group delay ($\tau$) caused by a device under test (14, 14A, 14B), comprising the steps:

   - generating a modulated test signal ($s_{test}$(t)) comprising a plurality of spectral lines each having a different frequency, by amplitude modulating a carrier signal, which contains multiple sine waves of defined frequencies ($\omega_K$) with a modulating signal, which contains at least one sine wave,
   - providing the device under test (14) with said modulated test signal ($s_{test}$(t)),
   - measuring a phase distorted, modulated response signal ($s_{resp}$(t)) caused by said device under test (14) provided with said modulated test signal ($s_{test}$(t)),
   - for at least some of said defined frequencies ($\omega_K$) of the carrier signal,

      - detecting phases of at least two spectral lines of said modulated response signal ($s_{resp}$(t)),
      - calculating at least one phase difference ($\Delta\varphi$) between said phases of said two of said spectral lines of said modulated response signal ($s_{resp}$(t)), and

   - calculating said group delay ($\tau_K$) for the at least some of said defined frequencies ($\omega_K$) by using said phase differences ($\Delta\varphi_K$) at said defined frequencies ($\omega_K$).

2. A method of determining the group delay according to claim 1,
   wherein said modulated test signal ($s_{test}$(t)) is an amplitude modulated test signal, and
   wherein said phase distorted, modulated response signal ($s_{resp}$(t)) is a phase distorted amplitude modulated response signal.

3. A method of determining the group delay according to claim 2,
   wherein said device under test (14, 14A, 14B) is an analogue-digital-converter (16) generating a digital amplitude modulated response signal ($s_{respD}$(t)) and the amplitude modulated test signal ($s_{test}$(t)) is an analogue signal.

4. A method of determining the group delay according to claim 2,
   wherein said amplitude modulated response signal ($s_{resp}$(t)) generated from the device under test (14A) is an analogue signal and is converted to a digital amplitude modulated response signal ($s_{respD}$(t)) by a succeeding calibrated analogue-digital-converter (30) and the amplitude modulated test signal ($s_{test}$(t)) is an analogue signal.

5. A method of determining the group delay according to claim 3 or 4,
   wherein said analogue amplitude modulated test signal ($s_{test}$(t)) is first generated digitally by a digital signal processor (25) and then converted to an analogue amplitude modulated test signal ($s_{test}$(t)) by a calibrated digital-analogue-converter (27).

6. A method of determining the group delay according to claim 2,
   wherein the device under test (14, 14A, 14B) is a digital-analogue-converter (31) provided with a digital amplitude modulated test signal ($s_{testD}$(t)) generated from a digital signal processor (25) which generates an analogue amplitude modulated response signal ($s_{resp}$(t)) converted to a digital amplitude modulated response signal ($s_{respD}$(t)) by a succeeding calibrated analogue-digital-converter(30).

7. A method of determining the group delay according to any of claims 2 to 6,
   wherein said amplitude modulated test signal ($s_{test}$(t)) is generated by at least one modulation signal (m(t)) with a frequency $\omega_m$ and a sequence (c(t)) of carrier signals each having a frequency k*$\Omega$, where $\Omega$ is a minimum frequency spacing between two frequencies $\omega_K$ and $\omega_{K+1}$ within said sequence (c(t)) of carrier signals and k is a positive integer factor.

8. A method of determining the group delay according to claim 7,
   wherein in the case of a constant group delay in the surrounding of each carrier frequency $\omega_K$ said group delay $\tau_K$ is calculated by the equations:

$$\tau_K \;=\; \tau(\omega_K) \;=\; \frac{\Delta\varphi_K - 2*\varphi_m}{2*\omega_m}$$

$$\tau_K \; = \; \tau(\omega_K) \; = \; \tau(\omega_K + \omega_m) \; = \; \tau(\omega_K - \omega_m),$$

$$\omega_K \; = \; k \star \Omega_c,$$

where

$\tau_K$ is said group delay in the surrounding of said specific frequency $\omega_K$ within said sequence c(t) of carrier signals,
$\omega_K$ is a specific frequency within said sequence c(t) of carrier signals,
$\Omega_c$ is said minimum frequency spacing between two frequencies $\omega_K$ and $\omega_{K+1}$ within said sequence c(t) of carrier signals,
K is said positive integer factor,
$\omega_m$ is said frequency of said modulation signal m(t),
$\Delta\varphi_K$ is said phase difference between two of said spectral lines of said modulated response signal $s_{resp}(t)$ at said specific frequency $\omega_K$ of said carrier signal c(t) and
$\varphi_m$ is a phase of said modulation signal m(t).

9. A method of determining the group delay according to claim 8,
wherein in the case of a constant group delay $\tau_K$ in the surrounding of each carrier frequency $\omega_K$ and each reference carrier frequency $\omega_{K0}$ a difference of said group delay $\tau_K$ is calculated by the equations:

$$\tau_K \; - \; \tau_{K0} \; = \; \frac{\Delta\varphi_K - \Delta\varphi_{K0}}{2 \star \omega_m},$$

$$\tau_K \; = \; \tau(\omega_K) \; = \; \tau(\omega_K + \omega_m) \; = \; \tau(\omega_K - \omega_m),$$

$$\tau_{K0} \; = \; \tau(\omega_{K0}) \; = \; \tau(\omega_{K0} + \omega_m) \; = \; \tau(\omega_{K0} - \omega_m),$$

$$\omega_K \; = \; K \star \Omega_c,$$

$$\omega_{K0} \; = \; K_0 \star \Omega_c,$$

$$\Delta\varphi_0 \; \approx \; 2 \star \Delta\varphi_1 - \Delta\varphi_2,$$

where

$\tau_K$ is said group delay in the surrounding of said specific frequency $\omega_K$ within said sequence c(t) of carrier signals,
$\tau_{K0}$ is said group delay in the surrounding of said specific reference frequency $\omega_{K0}$ within said carrier signal c(t),
$\omega_K$ is a specific frequency within said sequence c(t) of carrier signals,
$\omega_{K0}$ is a specific reference frequency within said carrier signal c(t),
$\Omega_c$ is said minimum frequency spacing between two frequencies $\omega_K$ $\omega_{K+1}$ within said sequence c(t) of carrier signals,
K, $K_0$ are positive integer factors,
$\omega_m$ is said frequency of said modulation signal m(t),
$\Delta\varphi_K$ is said phase difference between two of said spectral lines of said modulated response signal $s_{resp}(t)$ at said specific frequency $\omega_K$ of said sequence c(t) of carrier signals and
$\Delta\varphi_{K0}$ is said phase difference between two of said spectral lines of said modulated response signal $s_{resp}(t)$ at said specific frequency $\omega_{K0}$ within said sequence c(t) of carrier signals.

10. A method of determining the group delay according to claim 9,

wherein in the case of a variable group delay $\tau_K$ in the surrounding of each carrier frequency $\omega_K$ said group delay $\tau_K$ is calculated by the equations:

$$\tau_K \;=\; \Omega_c / (2 * \omega_m * \omega_K) * \sum_{n=0}^{k} \Delta\varphi_n \; - \varphi_m / \omega_m ,$$

$$\tau_K \;=\; \tau(\omega_K) \;=\; \tau(\omega_K + \omega_m) \;=\; \tau(\omega_K - \omega_m) ,$$

$$\omega_K \;=\; k * \Omega_c ,$$

$$\Delta\varphi_0 \;\approx\; 2 * \Delta\varphi_1 - \Delta\varphi_2 ,$$

where

$\tau_K$ is said group delay in the surrounding of said specific frequency $\omega_K$ within said sequence c(t) of carrier signals,
$\omega_K$ is a specific frequency within said sequence c(t) of carrier signals,
$\Omega_c$ is said minimum frequency spacing between two frequencies $\omega_K$ and $\omega_{K+1}$ of said carrier signal c(t),
k is said positive integer factor,
$\omega_m$ is said frequency of said modulation signal m(t),
$\Delta\varphi_n$ is said phase difference between two of said spectral lines of said modulated response signal $s_{resp}(t)$ at said specific frequency $\omega_n$ of said carrier signal c(t) and
$\varphi_m$ is a phase of said modulation signal m(t).

11. A method of determining the group delay according to claim 10,
wherein in the case of a variable group delay $\tau_K$ in the surrounding of each carrier frequency $\omega_K$ and each reference carrier frequency $\omega_{K0}$ a difference of said group delay $\tau_K$ is calculated by the equations:

$$\tau_K - \tau_{K0} \;=\; \Omega_c / (2 * \omega_m) \, [1/\omega_K * \sum^{k} \Delta\varphi_n \; - 1/\omega_{K0} * \sum^{k_0} \Delta\varphi_n \, ],$$

$$\tau_K \;=\; \tau(\omega_K) \;=\; \tau(\omega_K + \omega_m) \;=\; \tau(\omega_K - \omega_m) ,$$

$$\tau_{K0} \;=\; \tau(\omega_{K0}) \;=\; \tau(\omega_{K0} + \omega_m) \;=\; \tau(\omega_{K0} - \omega_m) ,$$

$$\omega_K \;=\; k * \Omega_c ,$$

$$\omega_{K0} \;=\; k_0 * \Omega_c ,$$

$$\Delta\varphi_0 \;\approx\; 2 * \Delta\varphi_1 - \Delta\varphi_2 ,$$

where

$\tau_K$ is said group delay in the surrounding of said specific frequency $\omega_K$ within said sequence c(t) of carrier signals,
$\tau_{K0}$ is said group delay in the surrounding of said specific reference frequency $\omega_{K0}$ within said carrier signal c(t),
$\omega_K$ is a specific frequency within said sequence c(t) of carrier signals,
$\omega_{K0}$ is a specific reference frequency within said carrier signal c(t),
$\Omega_c$ is said minimum frequency spacing between two frequencies $\omega_K$ and $\omega_{K+1}$ of said carrier signal c(t),

K, $K_0$ are positive integer factors,

$\omega_m$ is said frequency of said modulation signal m(t) and

$\Delta\varphi_n$ is said phase difference between two of said spectral lines of said modulated response signal $s_{resp}$(t) at said specific frequency $\omega_n$ of said sequence c(t) of carrier signals.

12. A method of determining the group delay according to any of claims 7 to 11,
wherein the frequency $\omega_m$ of said modulation signal (m(t)) and the minimum frequency spacing $\Omega$ between two frequencies $\omega_K$ and $\omega_{K+1}$ of said sequence (c(t)) of carrier signals is generated by a reference frequency $f_{REF}$ corresponding to the equations:

$$\omega_m = n * f_{REF}$$

and

$$\Omega_c = m * f_{REF},$$

where n and m are positive integer factors, whose selected values ensure that said spectral lines of the modulated test signal ($s_{test}$(t)) have different frequencies.

13. A method of determining the group delay according to claim 12,
wherein the frequency spacing $\Omega$ between two adjacent spectral lines of said modulated test signal is equal.

14. A method of determining the group delay according to claim 13,
wherein in the case of equal frequency spacing $\Omega$ between two adjacent spectral lines of said modulated test signal ($s_{test}$(t)) the frequency $\omega_m$ of said modulation signal (m(t)) and the minimum frequency spacing $\Omega$ between two frequencies $\omega_K$ and $\omega_{K+1}$ of said carrier signal (c(t)) are equal.

15. A method of determining the group delay according to any of claims 1 to 14,
wherein the phase of said spectral line of the said modulated response signal ($s_{resp}$(t)) is determined by performing the Fourier-Transformation of said modulated response signal ($s_{resp}$(t)).

16. A method of determining the group delay according to claim 15,
wherein said Fourier-Transformation is a Fast-Fourier-Transformation or a Discrete-Fourier-Transformation both delivering a complex value pair - amplitude and phase - for each spectral line.

17. A method of determining the group delay according to claim 16,
wherein all said spectral lines within one period of a spectrum of said sampled, modulated response signal ($s_{resp}$(t)) is imaged to a frequency grid of said Fast-Fourier-Transformation or said Discrete-Fourier-Transformation.

18. A method of determining the group delay according to claim 17,
wherein for the imaging of all said spectral lines within one period of said spectrum of said sampled, modulated response signal ($s_{resp}$(t)) to said frequency grid of said discrete Fast-Fourier-Transformation the frequency spacing $\Omega_c$ between two frequencies $\omega_K$ and $\omega_{K+1}$ of said carrier signal (c(t)) and the frequency $\omega_m$ of said modulation signal (m(t)) are determined by the equation:

$$\frac{\Omega_c}{m} = \frac{\omega_m}{n} = f_{ref} = \frac{2\pi f_0}{N}$$

where

$f_0$ is the sampling frequency of the said modulated response signal $s_{resp}$(t) and
N is the number of samples of said Fast-Fourier-Transformation or said Discrete-Fourier-Transformation in the time domain and in the frequency domain.

**19.** An apparatus for determining the group delay ($\tau$) caused by a device under test (14) comprising:

a test signal generator (1) for generating a modulation signal (m(t)), which contains at least one sine wave and a carrier signal, which contains multiple sine waves of defined frequencies ($\omega_K$),
a modulator (10) for mixing said carrier signal (c(t)) with said modulation signal (m(t)) to generate an analogue test signal ($s_{test}$(t)),
a device under test (14) provided with said test signal ($s_{test}$(t)),
a measuring device (21) for measuring a response signal ($s_{resp}$(t)) of said device under test (14) provided with said test signal ($s_{test}$(t)), and
a Fourier analyser (23) for determining the Fourier spectral lines of said response signal ($s_{resp}$(t)), wherein the apparatus is adapted to, for at least some of said defined frequencies ($\omega_K$) of the carrier signal,

- detect phases of at least two spectral lines of said modulated response signal ($s_{resp}$(t)),
- calculate at least one phase difference ($\Delta\varphi$) between said phases of said two of said spectral lines of said modulated response signal ($s_{resp}$(t)), and

calculate said group delay ($\tau_K$) for the at least some of said defined frequencies ($\omega_K$) by using said phase differences ($\Delta\varphi_K$) at said defined frequencies ($\omega_K$).

**20.** An apparatus for determining the group delay according to claim 19,
wherein said test signal generator (1) and/or said measuring device (21) comprises an anti-aliasing-filter (28, 28')
for suppressing all the frequencies of said test signal ($s_{test}$(t)) above half the sampling frequency ($f_0$).

**21.** An apparatus for determining the group delay according to claim 20,
wherein the device under test (14, 14A, 14B) is an analogue-digital-converter (16) sampling said test signal $s_{test}$(t)
with a sampling frequency ($f_0$) and generating a digital response signal ($s_{respD}$(t)).

**22.** An apparatus for determining the group delay according to claim 21,
wherein the device under test (14, 14A, 14B) generates an analogue response signal ($s_{resp}$(t)) which is converted
to a digital response signal ($s_{respD}$(t)) by an analogue-digital-converter (30).

**23.** An apparatus for determining the group delay according to claim 21 or 22,
wherein said test signal generator (1) and said modulator (10) are implemented by a digital signal processor (25)
calculating a digital pulse amplitude modulated test signal ($s_{testD}$(t)) corresponding to said analogue test signal
($s_{test}$(t)) and a succeeding digital-analogue-converter (27) for generating an analogue amplitude modulated test
signal ($S_{test}$(t)).

**24.** An apparatus for determining the group delay according to claim 23,
wherein said device under test (14, 14A, 14B) is a digital-analogue-converter (31) provided with a digital pulse
amplitude modulated test signal ($s_{testD}$(t)) from a digital signal processor (25) which generates an analogue response
signal ($S_{resp}$(t)).

**25.** An apparatus of determining the group delay according to claim 23,
wherein said sequence (c(t)) of carrier signals for said analogue amplitude modulated test signal ($s_{test}$(t)) is first
generated digitally by said digital signal processor (25) and then converted to said analogue sequence (c(t)) of
carrier signals by a digital-analogue-converter (33) for mixing with said modulation signal (m(t)) by means of said
modulator (10) to said analogue amplitude modulated test signal ($s_{test}$(t)) .

**26.** An apparatus for determining the group delay according to claim 22 or 23,
wherein said apparatus further comprises a clock (24) for synchronising said test signal generator (14) and said
analogue-digital-converter (16, 30).

**27.** An apparatus for determining the group delay according to claim 22 or 23,
wherein said measuring device (21) is a transient analyser (21) for measuring said digital response signal ($s_{respD}$(t)).

**28.** An apparatus for determining the group delay according to claim 27,
wherein said Fourier analyser (23) is a digital Fast-Fourier-Analyser (23) or a digital Discrete-Fourier-Analyser (23)
for determining a complex Fourier spectrum of said digital response signal ($s_{respD}$(t)).

**29.** An apparatus for determining the group delay according to claim 24, wherein said digital signal processor (25) calculates a digital orthogonal frequency division multiplexing test signal ($s_{testOFDM}$(t)).

**30.** An apparatus for determining the group delay according to claim 29, wherein the phases within said digital orthogonal frequency division multiplexing test signal $s_{testOFDM}$(t) are chosen for an optimised crest-factor of said digital orthogonal frequency division multiplexing test signal $s_{testOFDM}$(t).

**Patentansprüche**

**1.** Verfahren zur Bestimmung der von einem zu testenden Bauteil (14, 14A, 14B) verursachten Gruppenlaufzeit (c), mit den folgenden Schritten:

- Erzeugen eines modulierten Testsignals ($s_{test}$(t)) mit einer Vielzahl von Spektrallinien jeweils mit einer unterschiedlichen Frequenz durch Amplituden-Modulieren eines Trägersignals, das mehrfache Sinuswellen von definierter Frequenz ($\omega_K$) mit einem Moduliersignal enthält, das mindestens eine Sinuswelle enthält,
- Versehen des zu testenden Bauteils mit dem modulierten Testsignal ($s_{test}$(t)),
- Messen eines von dem zu testenden Bauteil (14) verursachten, phasenverzerrten, modulierten Antwortsignals ($s_{resp}$(t)), das mit dem modulierten Testsignal ($s_{test}$(t)) versehen ist,
- für zumindest einige der definierten Frequenzen ($\omega_K$) des Trägersignals,

  - Erfassen von Phasen von mindestens zwei Spektrallinien des modulierten Antwortsignals ($s_{resp}$(t)),
  - Berechnen von zumindest einer Phasendifferenz ($\Delta\varphi$) zwischen den Phasen der beiden der Spektrallinien des modulierten Antwortsignals ($s_{resp}$(t)),

  und
- Berechnen der Gruppenlaufzeit ($\tau_K$) für die zumindest einigen der definierten Frequenzen ($\omega_K$) durch Einsatz der Phasendifferenzen ($\Delta\varphi_K$) an den definierten Frequenzen ($\omega_K$).

**2.** Verfahren zur Bestimmung der Gruppenlaufzeit nach Anspruch 1, wobei das modulierte Testsignal ($s_{test}$(t)) ein amplitudenmoduliertes Testsignal ist, und wobei das phasenverzerrte, modulierte Antwortsignal ($s_{resp}$(t)) ein phasenverzerrtes, amplitudenmoduliertes Antwortsignal ist.

**3.** Verfahren zur Bestimmung der Gruppenlaufzeit nach Anspruch 2, wobei das zu testende Bauteil (14, 14A, 14B) ein Analog-digital-Wandler (16) ist, der ein digitales, amplitudenmoduliertes Antwortsignal ($s_{respD}$(t)) erzeugt, und das amplitudenmodulierte Testsignal ($s_{test}$(t)) ein analoges Signal ist.

**4.** Verfahren zur Bestimmung der Gruppenlaufzeit nach Anspruch 2, wobei das von dem zu testenden Bauteil (14A) erzeugte, amplitudenmodulierte Antwortsignal ($s_{resp}$(t)) ein analoges Signal darstellt und durch einen nachfolgenden kalibrierten Analog-digital-Wandler (30) in ein digitales, amplitudenmoduliertes Antwortsignal ($s_{respD}$(t)) umgewandelt wird und das amplitudenmodulierte Testsignal ($s_{test}$(t)) ein analoges Signal darstellt.

**5.** Verfahren zur Bestimmung der Gruppenlaufzeit nach Anspruch 3 oder 4, wobei das analoge, amplitudenmodulierte Testsignal ($s_{test}$(t)) zunächst digital von einem digitalen Signalprozessor (25) erzeugt wird und danach durch einen kalibrierten Digital-analog-Wandler (27) in ein analoges, amplitudenmoduliertes Testsignal ($s_{test}$(t)) umgewandelt wird.

**6.** Verfahren zur Bestimmung der Gruppenlaufzeit nach Anspruch 2, wobei das zu testende Bauteil (14, 14A, 14B) ein Digital-analog-Wandler (31) ist, der mit einem digitalen, amplitudenmodulierten Testsignal ($s_{testD}$(t)) versehen ist, das von einem digitalen Signalprozessor (25) erzeugt wird, welcher ein analoges, amplitudenmoduliertes Antwortsignal ($s_{resp}$(t)) erzeugt, das von einem nachfolgenden kalibrierten Analog-digital-Wandler (30) in ein digitales, amplitudenmoduliertes Antwortsignal ($s_{respD}$(t)) umgewandelt wird.

**7.** Verfahren zur Bestimmung der Gruppenlaufzeit nach einem der Ansprüche 2 bis 6, wobei das amplitudenmodulierte Testsignal ($s_{test}$(t)) von mindestens einem Modulationssignal (m(t)) mit einer Frequenz $\omega_m$ und einer Sequenz (c(t)) von Trägersignalen jeweils mit einer Frequenz k*$\Omega$ erzeugt wird, wobei

$\Omega$ ein Mindestfrequenzabstand zwischen zwei Frequenzen $\omega_k$ und $\omega_{k+1}$ innerhalb der Sequenz (c(t)) von Trägersignalen ist und k ein positiver ganzzahliger Faktor ist.

8. Verfahren zur Bestimmung der Gruppenlaufzeit nach Anspruch 7,
   wobei im Falle einer konstanten Gruppenlaufzeit in der Umgebung jeder Trägerfrequenz $\omega_K$ die Gruppenlaufzeit $\tau_K$ durch die folgenden Gleichungen berechnet wird:

$$\tau_K = \tau(\omega_K) = \frac{\Delta\varphi_K - 2*\varphi_m}{2*\omega_m}$$

$$\tau_K = \tau(\omega_K) = \tau(\omega_K + \omega_m) = \tau(\omega_K - \omega_m),$$

$$\omega_K = k*\Omega_c,$$

wobei

$\tau_K$ die Gruppenlaufzeit in der Umgebung der spezifischen Frequenz $\omega_K$ innerhalb der Sequenz c(t) von Trägersignalen darstellt,
$\omega_K$ eine spezifische Frequenz innerhalb der Sequenz c(t) von Trägersignalen darstellt,
$\Omega_c$ den Mindestfrequenzabstand zwischen zwei Frequenzen $\omega_K$ und $\omega_{K+1}$ innerhalb der Sequenz c(t) von Trägersignalen darstellt,
K den positiven geradzahligen Faktor darstellt,
$\omega_m$ die Frequenz des Modulationssignals m(t) darstellt,
$\Delta\varphi_K$ die Phasendifferenz zwischen zwei der Spektrallinien des modulierten Antwortsignals $s_{resp}(t)$ bei der speziellen Frequenz $\omega_K$ des Trägersignals c(t) darstellt, und
$\varphi_m$ eine Phase des Modulationssignals m(t) darstellt.

9. Verfahren zur Bestimmung der Gruppenlaufzeit nach Anspruch 8,
   wobei im Falle einer konstanten Gruppenlaufzeit $\tau_K$ in der Umgebung jeder Trägerfrequenz $\omega_K$ und jeder Bezugsträgerfrequenz $\omega_{K0}$ eine Differenz der Gruppenlaufzeit $\tau_K$ durch folgende Gleichungen berechnet wird:

$$\tau_K - \tau_{K0} = \frac{\Delta\varphi_K - \Delta\varphi_{K0}}{2*\omega_m},$$

$$\tau_K = \tau(\omega_K) = \tau(\omega_K + \omega_m) = \tau(\omega_K - \omega_m),$$

$$\tau_{K0} = \tau(\omega_{K0}) = \tau(\omega_{K0} + \omega_m) = \tau(\omega_{K0} - \omega_m),$$

$$\omega_K = K*\Omega_c,$$

$$\omega_{K0} = K_0*\Omega_c,$$

$$\Delta\varphi_0 \approx 2*\Delta\varphi_1 - \Delta\varphi_2,$$

wobei

$\tau_K$ die Gruppenlaufzeit in der Umgebung der spezifischen Frequenz $\omega_K$ innerhalb der Sequenz c(t) von Träger-

signalen darstellt,

$\tau_{K0}$ die Gruppenlaufzeit in der Umgebung der spezifischen Bezugsfrequenz $\omega_{K0}$ innerhalb des Trägersignals c(t) darstellt,

$\omega_K$ eine spezifische Frequenz innerhalb der Sequenz c(t) von Trägersignalen darstellt,

$\omega_{K0}$ eine spezifische Bezugsfrequenz innerhalb des Trägersignals c(t) darstellt,

$\Omega_c$ den Mindestfrequenzabstand zwischen zwei Frequenzen $\omega_K$ und $\omega_{K+1}$ innerhalb der Sequenz c(t) von Trägersignalen darstellt,

$K$, $K_0$ positive geradzahlige Faktoren sind,

$\omega_m$ die Frequenz des Modulationssignals m(t) darstellt,

$\Delta\varphi_K$ die Phasendifferenz zwischen zwei der Spektrallinien des modulierten Antwortsignals $s_{resp}(t)$ mit der spezifischen Frequenz $\omega_K$ der Sequenz c(t) der Trägersignale darstellt, und

$\Delta\varphi_{K0}$ die Phasendifferenz zwischen zwei der Spektrallinien des modulierten Antwortsignals $s_{resp}(t)$ bei der spezifischen Frequenz $\omega_{K0}$ innerhalb der Sequenz c(t) von Trägersignalen darstellt.

**10.** Verfahren zur Bestimmung der Gruppenlaufzeit nach Anspruch 9,
wobei im Falle einer variablen Gruppenlaufzeit $\tau_K$ in der Umgebung jeder Trägerfrequenz $\omega_K$ die Gruppenlaufzeit $\tau_K$ durch die folgenden Gleichungen berechnet wird:

$$\tau_K = \Omega_c / (2 * \omega_m * \omega_K) * \sum_{n=0}^{k} \Delta\varphi_n - \varphi_m / \omega_m,$$

$$\tau_K = \tau(\omega_K) = \tau(\omega_K + \omega_m) = \tau(\omega_K - \omega_m),$$

$$\omega_K = k * \Omega_c,$$

$$\Delta\varphi_0 \approx 2 * \Delta\varphi_1 - \Delta\varphi_2,$$

wobei

$\tau_K$ die Gruppenlaufzeit in der Umgebung der spezifischen Frequenz $\omega_K$ innerhalb der Sequenz c(t) von Trägersignalen darstellt,

$\omega_K$ eine spezifische Frequenz innerhalb der Sequenz c(t) von Trägersignalen darstellt,

$\Omega_c$ den Mindestfrequenzabstand zwischen zwei Frequenzen $\omega_K$ und $\omega_{K+1}$ des Trägersignals c(t) darstellt,

$k$ der positive geradzahlige Faktor ist,

$\omega_m$ die Frequenz des Modulationssignals m(t) darstellt,

$\Delta\varphi_n$ die Phasendifferenz zwischen zwei der Spektrallinien des modulierten Antwortsignals $s_{resp}(t)$ mit der spezifischen Frequenz $\omega_n$ des Trägersignals c(t) darstellt, und

$\varphi_m$ eine Phase des Modulationssignals m(t) darstellt.

**11.** Verfahren zur Bestimmung der Gruppenlaufzeit nach Anspruch 10,
wobei im Falle einer variablen Gruppenlaufzeit $\tau_K$ in der Umgebung jeder Trägerfrequenz $\omega_K$ und jeder Bezugsträgerfrequenz $\omega_{K0}$ eine Differenz der Gruppenlaufzeit $\tau_K$ durch die folgenden Gleichungen berechnet wird:

$$\tau_K - \tau_{K0} = \Omega_c / (2 * \omega_m) [1/\omega_K * \sum^{k} \Delta\varphi_n - 1/\omega_{K0} * \sum^{k_0} \Delta\varphi_n],$$

$$\tau_K = \tau(\omega_K) = \tau(\omega_K + \omega_m) = \tau(\omega_K - \omega_m),$$

$$\tau_{K0} = \tau(\omega_{K0}) = \tau(\omega_{K0} + \omega_m) = \tau(\omega_{K0} - \omega_m),$$

$$\omega_K = k \ast \Omega_c,$$

$$\omega_{K0} = k_0 \ast \Omega_c,$$

$$\Delta\varphi_0 \approx 2 \ast \Delta\varphi_1 - \Delta\varphi_2,$$

wobei

$\tau_K$ die Gruppenlaufzeit in der Umgebung der spezifischen Frequenz $\omega_K$ innerhalb der Sequenz c(t) von Träger-signalen darstellt,
$\tau_{K0}$ die Gruppenlaufzeit in der Umgebung der spezifischen Bezugsfrequenz $\omega_{K0}$ innerhalb des Trägersignals c(t) darstellt,
$\omega_K$ eine spezifische Frequenz innerhalb der Sequenz c(t) von Trägersignalen darstellt,
$\omega_{K0}$ eine spezifische Bezugsfrequenz innerhalb des Trägersignals c(t) darstellt,
$\Omega_c$ den Mindestfrequenzabstand zwischen zwei Frequenzen $\omega_K$ und $\omega_{K+1}$ desTrägersignals c(t) darstellt,
K, $K_0$ positive geradzahlige Faktoren sind,
$\omega_m$ die Frequenz des Modulationssignals m(t) darstellt, und
$\Delta\varphi_n$ die Phasendifferenz zwischen zwei der Spektrallinien des modulierten Antwortsignals $s_{resp}$(t) mit der spe-zifischen Frequenz $\omega_n$ der Sequenz c(t) von Trägersignalen darstellt.

12. Verfahren zur Bestimmung der Gruppenlaufzeit nach einem der Ansprüche 7 bis 11, wobei die Frequenz $\omega_m$ des Modulationssignals (m(t)) und der Mindestfrequenzabstand $\Omega$ zwischen zwei Frequenzen $\omega_K$ und $\omega_{K+1}$ der Sequenz c(t) von Trägersignalen von einer Bezugsfrequenz $f_{REF}$ entsprechend den Gleichungen erzeugt wird:

$$\omega_m = n \ast f_{REF}$$

und

$$\Omega_c = m \ast f_{REF},$$

wobei
n und m positive geradzahlige Faktoren darstellen, deren ausgewählte Werte sicherstellen, dass die Spektrallinien des modulierten Testsignals ($s_{test}$(t)) unterschiedliche Frequenzen aufweisen.

13. Verfahren zur Bestimmung der Gruppenlaufzeit nach Anspruch 12,
wobei der Frequenzabstand $\Omega$ zwischen zwei angrenzenden Spektrallinien des modulierten Testsignals gleich ist.

14. Verfahren zur Bestimmung der Gruppenlaufzeit nach Anspruch 13,
wobei im Falle eines gleichen Frequenzabstandes $\Omega$ zwischen zwei angrenzenden Spektrallinien des modulierten Testsignals ($s_{test}$(t)) die Frequenz $\omega_m$ des Modulationssignals (m(t)) und der Mindestfrequenzabstand $\Omega$ zwischen zwei Frequenzen $\omega_K$ und $\omega_{K+1}$ des Trägersignals (c(t)) gleich sind.

15. Verfahren zur Bestimmung der Gruppenlaufzeit nach einem der Ansprüche 1 bis 14, wobei die Phase der Spektrallinie des modulierten Antwortsignals ($s_{resp}$(t)) durch die Durchführung der Fourier-Transformation des modulierten Ant-wortsignals ($s_{resp}$(t)) bestimmt wird.

16. Verfahren zur Bestimmung der Gruppenlaufzeit nach Anspruch 15,
wobei die Fourier-Transformation eine Fast-Fourier-Transformation oder eine Discrete-Fourier-Transformation darstellt, welche beide ein komplexes Wertepaar - Amplitude und Phase - für jede Spektrallinie liefern.

17. Verfahren zur Bestimmung der Gruppenlaufzeit nach Anspruch 16,
wobei alle Spektrallinien innerhalb eines Zeitraumes eines Spektrums des abgetasteten modulierten Antwortsignals

($s_{resp}$(t)) auf ein Frequenzraster der Fast-Fourier-Transformation oder der Discrete-Fourier-Transformation abgebildet werden.

18. Verfahren zur Bestimmung der Gruppenlaufzeit nach Anspruch 17, wobei für die Abbildung aller Spektrallinien innerhalb eines Zeitraumes des Spektrums des abgetasteten, modulierten Antwortsignals ($s_{resp}$(t)) auf das Frequenzraster der diskreten Fast-Fourier-Transformation der Frequenzabstand $\Omega_c$ zwischen zwei Frequenzen $\omega_K$ und $\omega_{K+1}$ des Trägersignals (c(t)) und die Frequenz $\omega_m$ des Modulationssignals (m(t)) durch die folgende Gleichung bestimmt werden:

$$\frac{\Omega_c}{m} = \frac{\omega_m}{n} = f_{ref} = \frac{2\pi f_0}{N}$$

wobei

$f_0$ die Abtastfrequenz des modulierten Antwortsignals $s_{resp}$(t) ist und
N die Anzahl von Mustern der Fast-Fourier-Transformation oder der Discrete-Fourier-Transformation in dem Zeitbereich und in dem Frequenzbereich ist.

19. Vorrichtung zur Bestimmung der von einem zu testenden Bauteil verursachten Gruppenlaufzeit ($\tau$), mit:

einem Testsignalerzeuger (1) zum Erzeugen eines Modulationssignals (m(t)), das mindestens eine Sinuswelle und ein Trägersignal enthält, welches mehrfache Sinuswellen definierter Frequenzen ($\omega_K$) enthält,
einem Modulator (10) zum Mischen des Trägersignals (c(t)) mit dem Modulationssignal (m(t)) zum Erzeugen eines analogen Testsignals ($s_{test}$(t)),
einem mit dem Testsignal ($s_{test}$(t)) versehen, zu testenden Bauteil (14),
einer Messvorrichtung (21) zum Messen eines Antwortsignals ($s_{resp}$(t)) des mit dem Testsignal ($s_{test}$(t)) versehenen, zu testenden Bauteils (14), und
einer Fourier Analyseeinheit (23) zum Bestimmen der Fourier Spektrallinien des Antwortsignals ($s_{resp}$(t)), wobei die Vorrichtung für zumindest einige der definierten Frequenzen ($\omega_K$) des Trägersignals dazu geeignet ist,

- Phasen von mindestens zwei Spektrallinien des modulierten Antwortsignals ($s_{resp}$(t)) zu erfassen,
- mindestens eine Phasendifferenz ($\Delta\varphi$) zwischen den Phasen der zwei der Spektrallinien des modulierten Antwortsignals ($s_{resp}$(t)) zu berechnen, und

die Gruppenlaufzeit ($\tau_K$) für die zumindest einigen der definierten Frequenzen ($\omega_K$) durch Einsatz der Phasendifferenzen ($\Delta\varphi_K$) bei den definierten Frequenzen ($\omega_K$) zu berechnen.

20. Vorrichtung zur Bestimmung der Gruppenlaufzeit nach Anspruch 19, wobei der Testsignalerzeuger (1) und/oder die Messvorrichtung (21) einen Anti-Aliasing-Filter (28, 28') zum Unterdrücken aller Frequenzen des Testsignals ($s_{test}$(t)) oberhalb der halben Abtastfrequenz ($f_0$) aufweist.

21. Vorrichtung zur Bestimmung der Gruppenlaufzeit nach Anspruch 20, wobei das zu testende Bauteil (14, 14A, 14B) ein Analog-digital-Wandler (16) ist, der das Testsignal ($s_{test}$(t) mit einer Abtastfrequenz ($f_0$) abtastet und ein digitales Antwortsignal ($s_{respD}$(t)) erzeugt.

22. Vorrichtung zur Bestimmung der Gruppenlaufzeit nach Anspruch 21, wobei das zu testende Bauteil (14, 14A, 14B) ein analoges Antwortsignal ($s_{resp}$(t)) erzeugt, das durch einen Analog-digital-Wandler (30) in ein digitales Antwortsignal ($s_{respD}$(t)) umgewandelt wird.

23. Vorrichtung zur Bestimmung der Gruppenlaufzeit nach Anspruch 21 oder 22, wobei der Testsignalerzeuger (1) und der Modulator (10) von einem digitalen Signalprozessor (25), der ein digitales, Impulsamplituden-moduliertes Testsignal ($s_{testD}$(t)) entsprechend dem analogen Testsignal ($s_{test}$(t)) berechnet, und einem nachfolgenden Digital-analog-Wandler (27) zum Erzeugen eines analogen amplitudenmodulierten Testsignals ($s_{test}$(t)) implementiert werden.

24. Vorrichtung zur Bestimmung der Gruppenlaufzeit nach Anspruch 23, wobei das zu testende Bauteil (14, 14A, 14B) ein Digital-analog-Wandler (31) ist, der mit einem digitalen Impulsamplituden-modulierten Testsignal ($s_{testD}$(t)) von einem digitalen Signalprozessor (25) versehen ist, welcher ein analoges Antwortsignal ($s_{resp}$(t)) erzeugt.

**25.** Vorrichtung zur Bestimmung der Gruppenlaufzeit nach Anspruch 23,
wobei die Sequenz (c(t)) von Trägersignalen für das analoge amplitudenmodulierte Testsignal ($s_{test}$(t)) zunächst digital von dem digitalen Signalprozessor (25) erzeugt wird und danach in die analoge Sequenz (c(t)) von Trägersignalen durch einen Digital-analog-Wandler (33) umgewandelt wird, um mit dem Modulationssignal (m(t)) mithilfe des Modulators (10) zu dem analogen amplitudenmodulierten Testsignal ($s_{test}$(t)) gemischt zu werden.

**26.** Vorrichtung zur Bestimmung der Gruppenlaufzeit nach Anspruch 22 oder 23,
wobei die Vorrichtung weiterhin einen Takt (24) zum Synchronisieren des Testsignalerzeugers (14) und des Analog-digital-Wandlers (16, 30) aufweist.

**27.** Vorrichtung zur Bestimmung der Gruppenlaufzeit nach Anspruch 22 oder 23,
wobei die Messvorrichtung (21) eine Übergangsanalyseeinheit (21) zum Messen des digitalen Antwortsignals ($s_{respD}$(t)) darstellt.

**28.** Vorrichtung zur Bestimmung der Gruppenlaufzeit nach Anspruch 27,
wobei die Fourier Analyseeinheit (23) eine digitale Fast-Fourier-Analyseeinheit (23) oder eine digitale Discrete-Fourier-Analyseeinheit (23) zum Bestimmen eines komplexen Fourier Spektrums des digitalen Antwortsignals ($s_{respD}$(t)) darstellt.

**29.** Vorrichtung zur Bestimmung der Gruppenlaufzeit nach Anspruch 24,
wobei der digitale Signalprozessor (25) ein digitales, orthogonales Frequenzmultiplex-Testsignal ($s_{testOFDM}$(t)) darstellt.

**30.** Vorrichtung zur Bestimmung der Gruppenlaufzeit nach Anspruch 29,
wobei die Phasen innerhalb des digitalen, orthogonalen Frequenzmultiplex-Testsignals $S_{testOFDM}$(t) für einen optimierten Scheitelfaktor des digitalen, orthogonalen Frequenzmultiplex-Testsignals $s_{testOFDM}$(t) ausgewählt werden.

**Revendications**

**1.** Procédé de détermination du retard de groupe ($\tau_K$) provoqué par un dispositif en essai (14, 14A, 14B), comportant les étapes consistant à :

- générer un signal d'essai modulé ($s_{test}$(t)) comportant une pluralité de raies spectrales ayant chacune une fréquence différente, en modulant l'amplitude d'un signal de porteuse, qui contient de multiples ondes sinusoïdales de fréquences ($\omega_K$) définies avec un signal de modulation, qui contient au moins une onde sinusoïdale,
- fournir au dispositif en essai (14) ledit signal d'essai modulé ($s_{test}$(t)),
- mesurer un signal de réponse modulé, ayant subi une distorsion de phase ($s_{resp}$(t)), provoqué par ledit dispositif en essai (14) ayant reçu ledit signal d'essai modulé ($s_{test}$(t)),
- pour au moins certaines desdites fréquences ($\omega_K$) définies du signal de porteuse,
- détecter des phases d'au moins deux raies spectrales dudit signal de réponse modulé ($s_{resp}$(t)),
- calculer au moins une différence de phase ($\Delta\varphi$) entre lesdites phases desdites deux raies spectrales dudit signal de réponse modulé ($s_{resp}$(t)), et
- calculer ledit retard de groupe ($\tau_K$) pour les au moins certaines desdites fréquences ($\omega_K$) définies en utilisant lesdites différences de phase ($\Delta\varphi_K$) auxdites fréquences ($\omega_K$) définies.

**2.** Procédé de détermination du retard de groupe selon la revendication 1,
dans lequel ledit signal d'essai modulé ($s_{test}$(t)) est un signal d'essai modulé en amplitude, et
dans lequel ledit signal de réponse modulé, ayant subi une distorsion de phase ($s_{resp}$(t)) est un signal de réponse modulé en amplitude ayant subi une distorsion de phase.

**3.** Procédé de détermination du retard de groupe selon la revendication 2,
dans lequel ledit dispositif en essai (14, 14A, 14B) est un convertisseur analogique-numérique (16) générant un signal de réponse numérique modulé en amplitude ($s_{respD}$(t)) et le signal d'essai modulé en amplitude ($s_{test}$(t)) est un signal analogique.

**4.** Procédé de détermination du retard de groupe selon la revendication 2, dans lequel ledit signal de réponse modulé en amplitude ($s_{resp}(t)$) généré à partir du dispositif en essai (14A) est un signal analogique et est converti en un signal de réponse numérique modulé en amplitude ($s_{respD}(t)$) par un convertisseur analogique-numérique calibré suivant (30) et le signal d'essai modulé en amplitude ($s_{test}(t)$) est un signal analogique.

**5.** Procédé de détermination du retard de groupe selon la revendication 3 ou 4, dans lequel ledit signal d'essai analogique modulé en amplitude ($s_{test}(t)$) est d'abord généré numériquement par un processeur de signal numérique (25) et ensuite converti en un signal d'essai analogique modulé en amplitude ($s_{test}(t)$) par un convertisseur numérique-analogique calibré (27).

**6.** Procédé de détermination du retard de groupe selon la revendication 2, dans lequel le dispositif en essai (14, 14A, 14B) est un convertisseur numérique-analogique (31) recevant un signal d'essai numérique modulé en amplitude ($s_{testD}(t)$) généré à partir d'un processeur de signal numérique (25) qui génère un signal de réponse analogique modulé en amplitude ($s_{resp}(t)$) converti en un signal de réponse numérique modulé en amplitude ($s_{respD}(t)$) par un convertisseur analogique-numérique calibré suivant (30).

**7.** Procédé de détermination du retard de groupe selon l'une quelconque des revendications 2 à 6, dans lequel ledit signal d'essai modulé en amplitude ($s_{test}(t)$) est généré par au moins un signal de modulation ($m(t)$) avec une fréquence $\omega_m$ et une séquence ($c(t)$) de signaux de porteuse ayant chacun une fréquence $k*\Omega$, où $\Omega$ est un espacement de fréquences minimal entre deux fréquences $\omega_K$ et $\omega_{K+1}$ dans ladite séquence ($c(t)$) de signaux de porteuse et k est un facteur entier positif.

**8.** Procédé de détermination du retard de groupe selon la revendication 7, dans lequel dans le cas d'un retard de groupe constant aux alentours de chaque fréquence porteuse $\omega_K$, ledit retard de groupe $\tau_K$ est calculé par les équations :

$$\tau_K = \tau(\omega_K) = \frac{\Delta\varphi_K - 2*\varphi_m}{2*\omega_m}$$

$$\tau_K = \tau(\omega_K) = \tau(\omega_K+\omega_m) = \tau(\omega_K-\omega_m),$$

$$\omega_K = k*\Omega_c,$$

où

$\tau_K$ est ledit retard de groupe aux alentours de ladite fréquence spécifique $\omega_K$ dans ladite séquence $c(t)$ de signaux de porteuse,
$\omega_K$ est une fréquence spécifique dans ladite séquence $c(t)$ de signaux de porteuse,
$\Omega_c$ est ledit espacement de fréquences minimal entre deux fréquences $\omega_K$ et $\omega_{K+1}$ dans ladite séquence ($c(t)$) de signaux de porteuse,
K est ledit facteur entier positif,
$\omega_m$ est ladite fréquence dudit signal de modulation $m(t)$,
$\Delta\varphi_K$ est ladite différence de phase entre deux desdites raies spectrales dudit signal de réponse modulé $s_{resp}(t)$ à ladite fréquence spécifique $\omega_K$ dudit signal de porteuse $c(t)$ et
$\varphi_m$ est une phase dudit signal de modulation $m(t)$.

**9.** Procédé de détermination du retard de groupe selon la revendication 8, dans lequel dans le cas d'un retard de groupe $\tau_K$ constant aux alentours de chaque fréquence porteuse $\omega_K$ et de chaque fréquence porteuse de référence $\omega_{K0}$, une différence dudit retard de groupe $\tau_K$ est calculée par les équations :

$$\tau_K - \tau_{K0} = \frac{\Delta\varphi_K - \Delta\varphi_{K0}}{2*\omega_m},$$

$$\tau_K = \tau(\omega_K) = \tau(\omega_K + \omega_m) = \tau(\omega_K - \omega_m),$$

$$\tau_{K0} = \tau(\omega_{K0}) = \tau(\omega_{K0} + \omega_m) = \tau(\omega_{K0} - \omega_m),$$

$$\omega_K = K \star \Omega_c,$$

$$\omega_{K0} = K_0 \star \Omega_c,$$

$$\Delta\varphi_0 \approx 2 \star \Delta\varphi_1 - \Delta\varphi_2,$$

où

$\tau_K$ est ledit retard de groupe aux alentours de ladite fréquence spécifique $\omega_K$ dans ladite séquence c(t) de signaux de porteuse,

$\tau_{K0}$ est ledit retard de groupe aux alentours de ladite fréquence de référence spécifique $\omega_{K0}$ dans ledit signal de porteuse c(t),

$\omega_K$ est une fréquence spécifique dans ladite séquence c(t) de signaux de porteuse,

$\omega_{K0}$ est une fréquence de référence spécifique dans ledit signal de porteuse c(t),

$\Omega_c$ est ledit espacement de fréquences minimal entre deux fréquences $\omega_K$ et $\omega_{K+1}$ dans ladite séquence c(t) de signaux de porteuse,

K, $K_0$ sont des facteurs entiers positifs,

$\omega_m$ est ladite fréquence dudit signal de modulation m(t),

$\Delta\varphi_K$ est ladite différence de phase entre deux desdites raies spectrales dudit signal de réponse modulé $s_{resp}(t)$ à ladite fréquence spécifique $\omega_K$ de ladite séquence c(t) de signaux de porteuse c(t)) et

$\Delta\varphi_{K0}$ est ladite différence de phase entre deux desdites raies spectrales dudit signal de réponse modulé $s_{resp}(t)$ à ladite fréquence spécifique $\omega_{K0}$ dans ladite séquence c(t) de signaux de porteuse c(t).

10. Procédé de détermination du retard de groupe selon la revendication 9,

dans lequel dans le cas d'un retard de groupe $\tau_K$ variable aux alentours de chaque fréquence porteuse $\omega_K$, ledit retard de groupe $\tau_K$ est calculé par les équations :

$$\tau_K = \Omega_c / (2 \star \omega_m \star \omega_K) \star \sum_{n=0}^{k} \Delta\varphi_n - \varphi_m / \omega_m,$$

$$\tau_K = \tau(\omega_K) = \tau(\omega_K + \omega_m) = \tau(\omega_K - \omega_m),$$

$$\omega_K = k \star \Omega_c,$$

$$\Delta\varphi_0 \approx 2 \star \Delta\varphi_1 - \Delta\varphi_2,$$

où

$\tau_K$ est ledit retard de groupe aux alentours de ladite fréquence spécifique $\omega_K$ dans ladite séquence c(t) de signaux de porteuse,

$\omega_K$ est une fréquence spécifique dans ladite séquence c(t) de signaux de porteuse,

$\Omega_c$ est ledit espacement de fréquences minimal entre deux fréquences $\omega_K$ et $\omega_{K+1}$ dudit signal de porteuse c(t),

k est ledit facteur entier positif,

$\omega_m$ est ladite fréquence dudit signal de modulation m(t),

$\Delta\varphi_n$ est ladite différence de phase entre deux desdites raies spectrales dudit signal de réponse modulé $s_{resp}(t)$ à ladite fréquence spécifique $\omega_n$ dudit signal de porteuse c(t) et

$\varphi_m$ est une phase dudit signal de modulation m(t).

11. Procédé de détermination du retard de groupe selon la revendication 10, dans lequel dans le cas d'un retard de groupe $\tau_K$ variable aux alentours de chaque fréquence porteuse $\omega_K$ et de chaque fréquence porteuse de référence $\omega_{K0}$, une différence dudit retard de groupe $\tau_K$ est calculée par les équations :

$$\tau_K - \tau_{K0} \ = \ \Omega_c / (2 \star \omega_m) \, [1/\omega_K \star \sum^{k} \Delta\varphi_n \, - 1/\omega_{K0} \star \sum^{k_0} \Delta\varphi_n \, ],$$

$$\tau_K' \ = \ \tau(\omega_K) \ = \ \tau(\omega_K + \omega_m) \ = \ \tau(\omega_K - \omega_m) \, ,$$

$$\tau_{K0} \ = \ \tau(\omega_{K0}) \ = \ \tau(\omega_{K0} + \omega_m) \ = \ \tau(\omega_{K0} - \omega_m) \, ,$$

$$\omega_K \ = \ k \star \Omega_c \, ,$$

$$\omega_{K0} \ = \ k_0 \star \Omega_c \, ,$$

$$\Delta\varphi_0 \ \approx \ 2 \star \Delta\varphi_1 - \Delta\varphi_2 \, ,$$

où

$\tau_K$ est ledit retard de groupe aux alentours de ladite fréquence spécifique $\omega_K$ dans ladite séquence c(t) de signaux de porteuse,

$\tau_{K0}$ est ledit retard de groupe aux alentours de ladite fréquence de référence spécifique $\omega_{K0}$ dans ledit signal de porteuse c(t),

$\omega_K$ est une fréquence spécifique dans ladite séquence c(t) de signaux de porteuse,

$\omega_{K0}$ est une fréquence de référence spécifique dans ledit signal de porteuse c(t),

$\Omega_c$ est ledit espacement de fréquences minimal entre deux fréquences $\omega_K$ et $\omega_{K+1}$ dudit signal de porteuse c(t),

K, $K_0$ sont des facteurs entiers positifs,

$\omega_m$ est ladite fréquence dudit signal de modulation m(t) et

$\Delta\varphi_n$ est ladite différence de phase entre deux desdites raies spectrales dudit signal de réponse modulé $s_{resp}(t)$ à ladite fréquence spécifique $\omega_n$ de ladite séquence c(t) de signaux de porteuse.

12. Procédé de détermination du retard de groupe selon l'une quelconque des revendications 7 à 11, dans lequel la fréquence $\omega_m$ dudit signal de modulation (m(t)) et l'espacement de fréquences minimal $\Omega$ entre deux fréquences $\omega_K$ et $\omega_{K+1}$ de ladite séquence (c(t)) de signaux de porteuse sont générés par une fréquence de référence $f_{REF}$ correspondant aux équations :

$$\omega_m \ = \ n \ \star \ f_{REF}$$

et

$$\Omega_c \ = \ m \ \star \ f_{REF} \, ,$$

où

n et m sont des facteurs entiers positifs, dont les valeurs sélectionnées garantissent que lesdites raies spectrales du signal d'essai modulé ($s_{test}(t)$) ont différentes fréquences.

**13.** Procédé de détermination du retard de groupe selon la revendication 12,
dans lequel l'espacement de fréquences $\Omega$ entre deux raies spectrales adjacentes dudit signal d'essai modulé est égal.

**14.** Procédé de détermination du retard de groupe selon la revendication 13,
dans lequel dans le cas d'un espacement de fréquences $\Omega$ égal entre deux raies spectrales adjacentes dudit signal d'essai modulé ($s_{test}(t)$), la fréquence $\omega_m$ dudit signal de modulation ($m(t)$) et l'espacement de fréquences minimal $\Omega$ entre deux fréquences $\omega_K$ et $\omega_{K+1}$ dudit signal de porteuse ($c(t)$) sont égaux.

**15.** Procédé de détermination du retard de groupe selon l'une quelconque des revendications 1 à 14,
dans lequel la phase de ladite raie spectrale dudit signal de réponse modulé ($s_{resp}(t)$) est déterminée en réalisant la transformation de Fourier dudit signal de réponse modulé ($s_{resp}(t)$).

**16.** Procédé de détermination du retard de groupe selon la revendication 15,
dans lequel ladite transformation de Fourier est une transformation de Fourier rapide ou une transformation de Fourier discrète fournissant toutes deux une paire de valeurs complexes - amplitude et phase - pour chaque raie spectrale.

**17.** Procédé de détermination du retard de groupe selon la revendication 16,
dans lequel toutes lesdites raies spectrales sur une période d'un spectre dudit signal de réponse modulé, échantillonné ($s_{resp}(t)$) sont représentées sur une grille de fréquences de ladite transformation de Fourier rapide ou de ladite transformation de Fourier discrète.

**18.** Procédé de détermination du retard de groupe selon la revendication 17,
dans lequel pour la représentation de toutes lesdites raies spectrales sur une période dudit spectre dudit signal de réponse modulé, échantillonné ($s_{resp}(t)$) sur ladite grille de fréquences de ladite transformation de Fourier rapide ou discrète, l'espacement de fréquences $\Omega_c$ entre deux fréquences $\omega_K$ et $\omega_{K+1}$ dudit signal de porteuse ($c(t)$) et la fréquence $\omega_m$ dudit signal de modulation ($m(t)$) sont déterminés par l'équation :

$$\frac{\Omega_c}{m} = \frac{\omega_m}{n} = f_{ref} = \frac{2\pi f_0}{N}$$

où

$f_0$ est la fréquence d'échantillonnage dudit signal de réponse modulé $s_{resp}(t)$ et
$N$ est le nombre d'échantillons de ladite transformation de Fourier rapide ou de ladite transformation de Fourier discrète dans le domaine temporel et dans le domaine fréquentiel.

**19.** Appareil pour déterminer le retard de groupe ($\tau_K$) provoqué par un dispositif en essai (14) comportant :

un générateur de signal d'essai (1) pour générer un signal de modulation ($m(t)$), qui contient au moins une onde sinusoïdale et un signal de porteuse, qui contient de multiples ondes sinusoïdales de fréquences ($\omega_K$) définies,
un modulateur (10) pour mélanger ledit signal de porteuse ($c(t)$) avec ledit signal de modulation ($m(t)$) pour générer un signal d'essai analogique ($s_{test}(t)$),
un dispositif en essai (14) recevant ledit signal d'essai ($s_{test}(t)$),
un dispositif de mesure (21) pour mesurer un signal de réponse ($s_{resp}(t)$) dudit dispositif en essai (14) recevant le signal d'essai ($s_{test}(t)$), et
un analyseur de Fourier (23) pour déterminer les raies spectrales de Fourier dudit signal de réponse ($s_{resp}(t)$),
dans lequel l'appareil est adapté pour, pour au moins certaines desdites fréquences ($\omega_K$) définies du signal de porteuse,

- détecter des phases d'au moins deux raies spectrales dudit signal de réponse modulé ($s_{resp}(t)$),
- calculer au moins une différence de phase ($\Delta\varphi$) entre lesdites phases desdites deux desdites raies spectrales dudit signal de réponse modulé ($s_{resp}(t)$), et

calculer ledit retard de groupe ($\tau_K$) pour les au moins certaines desdites fréquences ($\omega_K$) définies en utilisant lesdites différences de phase ($\Delta\varphi$) auxdites fréquences ($\omega_K$) définies.

**20.** Appareil pour déterminer le retard de groupe selon la revendication 19, dans lequel ledit générateur de signal d'essai (1) et/ou ledit dispositif de mesure (21) comporte un filtre anti repliement (28, 28') pour supprimer toutes les fréquences dudit signal d'essai ($s_{test}(t)$) supérieures à la moitié de la fréquence d'échantillonnage ($f_0$).

**21.** Appareil pour déterminer le retard de groupe selon la revendication 20, dans lequel le dispositif en essai (14, 14A, 14B) est un convertisseur analogique-numérique (16) échantillonnant ledit signal d'essai $s_{test}$ (t) avec une fréquence d'échantillonnage ($f_0$) et générant un signal de réponse numérique ($s_{respD}(t)$).

**22.** Appareil pour déterminer le retard de groupe selon la revendication 21, dans lequel le dispositif en essai (14, 14A, 14B) génère un signal de réponse analogique ($s_{resp}(t)$) qui est converti en un signal de réponse numérique ($s_{respD}(t)$) par un convertisseur analogique-numérique (30).

**23.** Appareil pour déterminer le retard de groupe selon la revendication 21 ou 22, dans lequel ledit générateur de signal d'essai (1) et ledit modulateur (10) sont mis en oeuvre par un processeur de signal numérique (25) calculant un signal d'essai numérique modulé en amplitude d'impulsion ($s_{test}(t)$) correspondant audit signal d'essai analogique ($s_{test}(t)$) et un convertisseur numérique-analogique suivant (27) pour générer un signal d'essai analogique modulé en amplitude ($s_{test}(t)$).

**24.** Appareil pour déterminer le retard de groupe selon la revendication 23, dans lequel ledit dispositif en essai (14, 14A, 14B) est un convertisseur numérique-analogique (31) recevant un signal d'essai numérique modulé en amplitude d'impulsion ($s_{testD}(t)$) provenant d'un processeur de signal numérique (25) qui génère un signal de réponse analogique ($s_{resp}(t)$) .

**25.** Appareil pour déterminer le retard de groupe selon la revendication 23, dans lequel ladite séquence ($c(t)$) de signaux de porteuse pour ledit signal d'essai analogique modulé en amplitude ($s_{test}(t)$) est d'abord générée numériquement par ledit processeur de signal numérique (25) et ensuite convertie en dite séquence analogique ($c(t)$) de signaux de porteuse par un convertisseur numérique-analogique (33) pour mélanger ledit signal de modulation ($m(t)$) au moyen dudit modulateur (10) audit signal d'essai analogique modulé en amplitude ($s_{test}(t)$) .

**26.** Appareil pour déterminer le retard de groupe selon la revendication 22 ou 23, dans lequel ledit appareil comporte en outre une horloge (24) pour synchroniser ledit générateur de signal d'essai (14) et ledit convertisseur analogique-numérique (16, 30).

**27.** Appareil pour déterminer le retard de groupe selon la revendication 22 ou 23, dans lequel ledit dispositif de mesure (21) est un analyseur de transitoires (21) pour mesurer ledit signal de réponse numérique ($s_{respD}(t)$).

**28.** Appareil pour déterminer le retard de groupe selon la revendication 27, dans lequel ledit analyseur de Fourier (23) est un analyseur numérique à transformation de Fourier rapide (23) ou un analyseur numérique à transformation de Fourier discrète (23) pour déterminer un spectre de Fourier complexe dudit signal de réponse numérique ($s_{respD}(t)$).

**29.** Appareil pour déterminer le retard de groupe selon la revendication 24, dans lequel ledit processeur de signal numérique (25) calcule un signal d'essai numérique de multiplexage par répartition orthogonale de la fréquence ($s_{testOFDM}(t)$).

**30.** Appareil pour déterminer le retard de groupe selon la revendication 29, dans lequel les phases dans le signal d'essai numérique de multiplexage par répartition orthogonale de la fréquence $s_{testOFDM}(t)$ sont choisies pour un facteur de crête optimisé dudit signal d'essai numérique de multiplexage par répartition orthogonale de la fréquence $s_{testOFDM}(t)$.

Fig. 1

Fig. 2

Fig. 3

Start

↓

generating an amplitude modulated test signal

$$s_{TEST}(t) = \frac{1}{2} \sum_{K=1}^{K} A_m \cdot A_k \cdot cos((\omega_k + \omega_m) \cdot t + \varphi_k + \varphi_m) + A_m \cdot A_k \cdot cos((\omega_k - \omega_m) \cdot t + \varphi_k - \varphi_m)$$

S10

↓

providing the device under test with the amplitude modulated test signal $s_{TEST}(t)$ — S20

↓

Linear case ?

yes → S30

measuring a phase distorted amplitude modulated response signal $s_{RESP}(t) =$

$$= \frac{1}{2} \sum_{k=1}^{K} \alpha_k [cos((\omega_k + \omega_m) \cdot t + \omega_k \cdot T_k + \varphi_k + \frac{1}{2}\Delta\varphi_k + cos((\omega_k - \omega_m) \cdot t + \omega_k \cdot T_k + \varphi_k - \frac{1}{2}\Delta\varphi_k)]$$

no → S40

measuring a phase distorted amplitude modulated response signal $s_{RESP}(t) =$

$$= \sum_{k=1}^{K} \alpha_k [cos((\omega_k + \omega_m) \cdot t + \omega_k \cdot T_k + \omega_m^2 \cdot T'_k + \varphi_k + \Delta\varphi_k/2) + cos((\omega_k - \omega_m) \cdot t + \omega_k \cdot T_k + \omega_m^2 \cdot T'_k + \varphi_k - \Delta\varphi_k/2)]$$

↓ ○ ↓

performing a Fast-Fourier-Transformation of the amplitude modulated response signal $s_{RESP}(t)$ — S50

↓

detecting the phase of spectral lines at the upper and lower sideband for each carrier frequency $\omega_k$ and calculating the phase difference $\Delta\varphi_k$ — S60

↓

Linear case ?

yes → S70

calculating the group delay $T_k =$

$$= \frac{\Delta\varphi_k - 2\varphi_m}{2\omega_m}$$ and the differrence of group delay

$$T_k - T_{k0} = \frac{\Delta\varphi_k - \Delta\varphi_{k0}}{2\omega_m}$$

no → S80

calculating the group delay

$$T_k = \frac{\Omega}{2\omega_k \omega_m} \sum_{n=0}^{K} \Delta\varphi(\omega_n) - \frac{\varphi_m}{\omega_m}$$

$$\Delta\varphi_0 \approx 2\Delta\varphi_1 - \Delta\varphi_2$$ and the differrence of group delay

$$T_k - T_{k0} = \frac{\Omega}{2\omega_m} [ \frac{1}{\omega_k} \sum_{n=0}^{K} \Delta\varphi(\omega_n) - \frac{1}{\omega_{k0}} \sum_{n=0}^{K} \Delta\varphi(\omega_n) ]$$

↓ ○ ↓

End

Fig. 4

Fig. 5

Fig. 6

Fig. 7

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4084132 A

**Non-patent literature cited in the description**

- **G. EBERSBERGER et al.** Television signal distortion in surface-wave filters and its measurement. *EBU Review/technical,* 01 February 1987, ISSN 0251-0936, 21-30